(19)

Europäisches Patentamt

European Patent Office

Office européen des brevets

(11)  EP 4 530 891 A1

(12)  EUROPEAN PATENT APPLICATION
published in accordance with Art. 153(4) EPC

(43)  Date of publication:
02.04.2025  Bulletin 2025/14

(21)  Application number: 23935627.2

(22)  Date of filing: 13.11.2023

(51)  International Patent Classification (IPC):
$G06F\ 18/23213^{(2023.01)}$

(52)  Cooperative Patent Classification (CPC):
Y02P 90/30

(86)  International application number:
PCT/CN2023/131179

(87)  International publication number:
WO 2025/035626 (20.02.2025 Gazette 2025/08)

(84)  Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30)  Priority: 14.08.2023  CN 202311022025

(71)  Applicant: TENCENT TECHNOLOGY (SHENZHEN)
COMPANY LIMITED
Shenzhen, Guangdong 518057 (CN)

(72)  Inventors:
• MA, Xingyu
Shenzhen, Guangdong 518057 (CN)
• HAO, Shaogang
Shenzhen, Guangdong 518057 (CN)
• ZHANG, Shengyu
Shenzhen, Guangdong 518057 (CN)

(74)  Representative: Nederlandsch Octrooibureau
P.O. Box 29720
2502 LS The Hague (NL)

(54)  **METHOD AND APPARATUS FOR DETERMINING PARAMETER OF LAYOUT QUALITY TEST TOOL, AND DEVICE AND MEDIUM**

(57)  A method and an apparatus for determining a parameter of a layout quality detection tool, a device, and a medium. The method includes: determining, for a target parameter of a quality detection tool, a plurality of first reference values within a pre-set value range and determining, from the pre-set value range excluding the determined first reference values, a plurality of first candidate values (201); performing a first quality detection on an original layout using the quality detection tool and based on the first reference values to obtain a first quality indicator set comprising one or more first quality indicators (202); in a case that the first quality indicator set does not meet a pre-defined quality condition, selecting a first target candidate value from the first candidate values based on the first quality indicator set, and determining, for the target parameter, a plurality of second reference values based on the first reference values and the first target candidate value (203); performing a second quality detection on the original layout using the quality detection tool and based on the second reference values to obtain a second quality indicator set comprising one or more second quality indicators (204); and in a case that the second quality indicator set meets the pre-defined quality condition, determining a target value of the target parameter of the quality detection tool using the second reference values (205). The accuracy of the tool is improved.

FIG. 2

## Description

RELATED APPLICATION

This application claims priority to Chinese Patent Application No. 202311022025.7, entitled "METHOD AND APPARATUS FOR DETERMINING PARAMETER OF LAYOUT QUALITY DETECTION TOOL, DEVICE, AND MEDIUM" filed on August 14, 2023, which is incorporated by reference in its entirety.

FIELD OF THE TECHNOLOGY

Embodiments of this application relate to the field of computer technologies, and in particular, to a method and an apparatus for determining a parameter of a quality detection tool (such as, layout quality detection tool), a device, and a medium.

BACKGROUND OF THE DISCLOSURE

With the development of computer technologies, integrated circuit technologies have also been developed, and an increasingly large number of layouts such as chip layouts, mask layouts, and wafer layouts have emerged. Layouts tend to have greatly varied quality, and therefore it is necessary to select a target layout from a plurality of candidate layouts.

In the related art, a plurality of candidate layouts may be inputted into a quality detection tool (such as, layout quality detection tool), and the quality detection tool determines quality indicators of the candidate layouts. If a quality indicator of one candidate layout is greater than an indicator threshold, the candidate layout is determined as a target layout. As can be learned, the accuracy of the quality detection tool is closely related to the accuracy of selecting the target layout, and a parameter of the quality detection tool determines the accuracy of the quality detection tool. Therefore, how to determine the parameter of the quality detection tool becomes a problem that needs to be resolved urgently.

SUMMARY

This application provides a method and an apparatus for determining a parameter of a quality detection tool (such as, layout quality detection tool), a device, and a medium, which can determine a value of a target parameter of a quality detection tool, thereby improving the accuracy of the quality detection tool. The technical solutions include the following content.

According to an aspect, a method for determining a parameter of a quality detection tool (such as, layout quality detection tool) is provided, the method being executable by an electronic device, the method including:

   determining, for a target parameter of a quality detection tool, a plurality of first reference values within a pre-set value range and determining, from the pre-set value range excluding the determined first reference values, a plurality of first candidate values;

   performing a first quality detection on an original layout using the quality detection tool and based on the first reference values to obtain a first quality indicator set comprising one or more first quality indicators;

   in a case that the first quality indicator set does not meet a pre-defined quality condition, selecting a first target candidate value from the first candidate values based on the first quality indicator set, and determining, for the target parameter, a plurality of second reference values based on the first reference values and the first target candidate value;

   performing a second quality detection on the original layout using the quality detection tool and based on the second reference values to obtain a second quality indicator set comprising one or more second quality indicators; and

   in a case that the second quality indicator set meets the pre-defined quality condition, determining a target value of the target parameter of the quality detection tool using the second reference values.

According to another aspect, an apparatus for determining a parameter of a quality detection tool is provided, the apparatus including:

   an acquisition module, configured to determine, for a target parameter of a quality detection tool, a plurality of first reference values within a pre-set value range and determine a plurality of first candidate values from the pre-set value range excluding the determined first reference values;

   a quality detection module, configured to perform a first quality detection on an original layout using the quality detection tool and based on the plurality of first reference values to obtain a first quality indicator set comprising one or more first quality indicators; and

   a determination module, configured to: in a case that the first quality indicator set does not meet a pre-defined quality condition, select a first target candidate value from the first candidate values based on the first quality indicator set, and determine, for the target parameter, a plurality of second reference values based on the first reference values and the first target candidate value;

   the quality detection module being further configured to perform a second quality detection on the original layout using the quality detection tool and based on the second reference values to obtain a second quality indicator set comprising one or more second quality indicators;

the determination module being further configured to: in a case that the second quality indicator set meets the pre-defined quality condition, determine a target value of the target parameter of the quality detection tool using the second reference values.

According to another aspect, an electronic device is provided, the electronic device including a processor and a memory, the memory having at least one computer program stored therein, the at least one computer program being loaded and executed by the processor, to cause the electronic device to implement any foregoing method for determining a parameter of a quality detection tool.

According to another aspect, a non-volatile computer-readable storage medium is further provided, the non-volatile computer-readable storage medium having at least one computer program stored therein, the at least one computer program being loaded and executed by a processor, to cause an electronic device to implement any foregoing method for determining a parameter of a quality detection tool.

According to another aspect, a computer program is further provided, at least one computer program product being provided, the at least one computer program being loaded and executed by a processor, to cause an electronic device to implement any foregoing method for determining a parameter of a quality detection tool.

According to another aspect, a computer program product is further provided, the computer program product having at least one computer program stored therein, the at least one computer program being loaded and executed by a processor, to cause an electronic device to implement any foregoing method for determining a parameter of a quality detection tool.

In the technical solutions provided in this application, a target parameter of a quality detection tool includes first reference values, and a first quality detection is performed on an original layout by using the quality detection tool to obtain first quality indicators corresponding to the first reference values. If the first quality indicators corresponding to the first reference values do not meet a pre-defined quality condition, a first target candidate value is determined from a plurality of first candidate values of the target parameter based on the first quality indicators corresponding to the first reference values, and a plurality of second reference values of the target parameter are determined based on the plurality of first reference values and the first target candidate value. The second reference values are determined, so that the accuracy of a value space of the target parameter is improved. A second quality detection is performed on the original layout by using the quality detection tool to obtain second quality indicators corresponding to the second reference values. The accuracy of the value space of the target parameter is improved, in order to improve the accuracy of the quality detection tool, so that the accuracy of quality indicators is improved, and in a case that the second quality indicators corresponding to the second reference values meet the pre-defined quality condition, a target value of the target parameter can be accurately determined based on the second reference values, thereby ensuring the accuracy of the quality detection tool, facilitating to improve the accuracy of quality indicators of to-be-detected layouts determined by the quality detection tool, and more accurately selecting a layout with better quality from the to-be-detected layouts.

BRIEF DESCRIPTION OF THE DRAWINGS

FIG. 1 is a schematic diagram of an implementation environment of a method for determining a parameter of a quality detection tool according to an embodiment of this application.

FIG. 2 is a flowchart of a method for determining a parameter of a quality detection tool according to an embodiment of this application.

FIG. 3 is a schematic diagram of a Pareto front between a mask error and a mask complexity according to an embodiment of this application.

FIG. 4 is a schematic flowchart of determining a parameter of a quality detection tool for a single quality indicator according to an embodiment of this application.

FIG. 5 is a schematic flowchart of determining a parameter of a quality detection tool for two quality indicators according to an embodiment of this application.

FIG. 6 is a schematic diagram of a relationship between a quantity of iterations and an edge distance error according to an embodiment of this application.

FIG. 7 is a schematic diagram of a relationship between an edge distance error and a complexity total variation according to an embodiment of this application.

FIG. 8 is a schematic structural diagram of an apparatus for determining a parameter of a quality detection tool according to an embodiment of this application.

FIG. 9 is a schematic structural diagram of a terminal device according to an embodiment of this application.

FIG. 10 is a schematic structural diagram of a server according to an embodiment of this application.

DESCRIPTION OF EMBODIMENTS

To make the objectives, technical solutions, and advantages of this application clearer, the following further describes implementations of this application in detail with reference to the accompanying drawings.

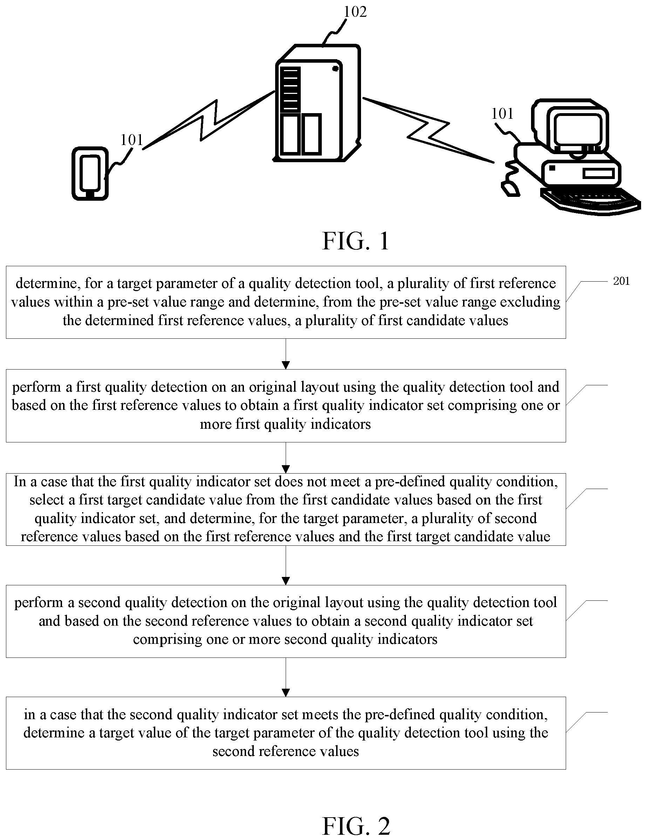

In the embodiments of the present disclosure including the embodiments of both the claims and the specification (hereinafter referred to as "all embodiments of the present disclosure"), FIG. 1 is a schematic diagram of an implementation environment of a method for determining a parameter of a quality detection tool (in all embodiments of the present disclosure, the quality detection tool can be a layout quality detection tool) according to an embodiment of this application. As shown in FIG. 1, the implementation environment can includes a terminal device 101 and a server 102. The method for determining a parameter of a quality detection tool in the embodiments of this application may be performed by the terminal device 101, or may be performed by the server 102, or may be jointly performed by the terminal device 101 and the server 102.

The terminal device 101 may be a smartphone, a video game console, a desktop computer, a tablet computer, a laptop portable computer, a smart TV, a smart in-vehicle device, a smart speech interaction device, a smart home appliance, or the like. The server 102 may be one server, or may be a server cluster formed by a plurality of servers, or may be any one of a cloud computing platform and a virtualization center. This is not limited in the embodiments of this application. The server 102 may be communicatively connected to the terminal device 101 by a wired network or a wireless network. The server 102 may have functions such as data processing, data storage, and data transmission and receiving. This is not limited in all embodiments of the present disclosure. A quantity of the terminal devices 101 and a quantity of the servers 102 are not limited, and one or more terminal devices or one or more servers may be used.

In the field of integrated circuit technologies, layouts can tend to have greatly varied quality. Based on this, a quality detection tool can usually determine quality indicators of candidate layouts. If a quality indicator of one candidate layout is greater than an indicator threshold, the candidate layout can be determined as a target layout. The accuracy of the quality detection tool is closely related to the accuracy of selecting the target layout, and a parameter of the quality detection tool can determine the accuracy of the quality detection tool. Therefore, how to determine the parameter of the quality detection tool becomes a problem that needs to be resolved urgently.

In all embodiments of the present disclosure, provided is a method for determining a parameter of a quality detection tool. The method may be applied to the foregoing implementation environment. A value of a target parameter of a quality detection tool can be determined, thereby improving the accuracy of the quality detection tool. A flowchart of the method for determining a parameter of a quality detection tool according to an embodiment of this application in FIG. 2 can be used as an example. For convenience of description, the terminal device 101 or the server 102 that performs the method for determining a parameter of a quality detection tool in the embodiments of this application can be referred to as an electronic device. The method may be performed by the electronic device. As shown in FIG. 2, the method can include the following Operation 201 to Operation 205:

201: Determine, for a target parameter of a quality detection tool, a plurality of first reference values within a pre-set value range and determine, from the pre-set value range excluding the determined first reference values, a plurality of first candidate values.

In all embodiments of the present disclosure, the quality detection tool can support a quality detection of layouts. The layouts can include, but not limited to, chip layouts, mask layouts, and wafer layouts. A chip layout is also referred to as an integrated circuit (IC) design layout. Generally, photolithography can be performed on a mask based on a chip layout to obtain a mask layout, and photolithography can be performed on a wafer based on the mask layout to obtain a wafer layout. The quality detection tool is not limited in all embodiments of the present disclosure. For example, the quality detection tool can include at least one of computer-aided design (CAD) software, electronic design automation (EDA) software, and the like.

In all embodiments of the present disclosure, the quality detection tool can have a large number of parameters. Some of these parameters are configured and cannot be adjusted, and some parameters can be adjusted. A parameter that can be adjusted is referred to as an adjustable parameter. A value of the adjustable parameter can be determined, so that the accuracy of the quality detection tool meets expectations. In all embodiments of the present disclosure, the target parameter is an adjustable parameter in the quality detection tool. The target parameter is not limited in all embodiments of the present disclosure. For example, the target parameter can include a learning rate, an iteration step, or the like. At least one target parameter can be used. To be specific, one or more target parameters may be used. Target parameters can have similar processing manners. Therefore, a parameter adjustment manner of the target parameter is described below without considering a quantity factor. To be specific, a process of determining a target value of the target parameter is described.

In all embodiments of the present disclosure, the electronic device may acquire the plurality of first reference values of the target parameter and the plurality of first candidate values of the target parameter. In some embodiments, the plurality of first reference values may also be referred to as multiple first reference values, or referred to as at least two first reference values; and the plurality of first candidate values may also be referred to as multiple first candidate values, or referred to as at least two first candidate values. Manners of acquiring the respective first reference value and the respective first candidate value are not limited in all embodiments of the present disclosure. For example, the electronic device can acquire inputted first reference values and first candidate values, or the electronic device can randomly generate first reference values and first candidate values.

In all embodiments of the present disclosure, Operation 201 can include: acquiring a first value range of the target parameter as the pre-set value range; dividing the first value range into a plurality of first value intervals; and performing a sampling in the first value intervals to obtain the plurality of first reference values and the plurality of first candidate values. A sampling can be performed in the plurality of first value intervals to obtain the first reference values and the first candidate values, which helps to improve the distribution uniformity of the first reference values and the first candidate values, thereby ensuring the comprehensiveness of the first reference values and the first candidate values.

In all embodiments of the present disclosure, the quality detection tool can be configured on the electronic device, and a user may input the first value range of the target parameter in the quality detection tool. Alternatively, the electronic device may generate the first value range. Alternatively, the electronic device may acquire the configured first value range.

Next, the electronic device may divide the first value range into a plurality of first value intervals by using a Latin hypercube sampling (LHS) method. Any two adjacent first value intervals may partially overlap or not overlap, and the two adjacent first value intervals may have the same length or different lengths. For any first value interval, at least one value can be sampled from the first value interval, and any value can be one first reference value or one first candidate value. In this manner, at least one value of the first reference values and the first candidate values can be sampled from any first value interval.

In all embodiments of the present disclosure, the "performing a sampling in the first value intervals to obtain the plurality of first reference values and the plurality of first candidate values" can include Operation 2011 to Operation 2013 (not shown in the figure).

Operation 2011: Perform the sampling in the first value intervals to obtain a plurality of first initial values of the target parameter.

In all embodiments of the present disclosure, the first value range can be divided into a plurality of first value intervals by using the Latin Hypercube Sampling method, at least one value can be sampled from the respective first value interval, and sampled values can be used as the first initial values. In this manner, the first initial values can be sampled from the first value intervals.

For example, K (K is a positive integer) target parameters are provided. For any target parameter, the first value range of the target parameter can be divided into L (L is an integer greater than 1) first value intervals that have the same length and do not overlap. For the respective first value interval, one value can be randomly sampled from the first value interval as one first initial value. Because one target parameter corresponds to the L first value intervals, L first initial values may be sampled for one target parameter, and a total of KL first initial values are sampled for the K target parameters.

In addition, in addition to inputting the first value range of the target parameter in the quality detection tool, the user may further input other information of the target parameter. For example, the user may further input a parameter type of the target parameter. Alternatively, the electronic device may acquire a parameter type of a configured target parameter. The parameter type of the target parameter may be a continuous parameter or a discrete parameter. The electronic device may sample at least one first initial value from any first value interval according to the parameter type of the target parameter. The first initial value sampled in this manner is a value that meets the parameter type of the target parameter, thereby ensuring the reliability of the first initial value.

In addition to sampling the plurality of first initial values from the first value ranges according to the Latin Hypercube Sampling method, a plurality of first initial values may be randomly sampled from the first value range according to a random sampling method. Compared with the random sampling method, during sampling according to the Latin Hypercube Sampling method, because the first initial values can be sampled from the plurality of first value intervals obtained by dividing the first value range, the distribution of the first initial values may be more uniform, thereby ensuring the comprehensiveness of the first initial values.

Next, the plurality of first initial values may be classified into the plurality of first reference values and the plurality of first candidate values in a random grouping manner. To be specific, for the respective first initial value, the first initial value may be randomly determined as one first reference value or one first candidate value. Alternatively, in a clustering manner, the first reference values and the first candidate values can be determined from the plurality of first initial values. The clustering manner is described below.

Operation 2012: Cluster the plurality of first initial values to obtain a plurality of target clusters, each of the target clusters including at least one first initial value.

In all embodiments of the present disclosure, the plurality of first initial values may be clustered by using any clustering algorithm to obtain a plurality of target clusters. The clustering algorithm is not limited in all embodiments of the present disclosure. For example, the clustering algorithm includes any one of a K-means clustering algorithm, a density-based clustering algorithm, a model-based clustering algorithm, a probability-based clustering algorithm, and the like. An implementation of clustering the plurality of first initial values is described below by using the K-means clustering algorithm as an example.

First, initial cluster centers of a set quantity M (M is a positive integer) can be acquired, and the set quantity M is configured to indicate a quantity of target clusters. A manner of determining M is not limited in all embodiments of the present disclosure. For example, the electronic device may acquire M inputted by the user, or the electronic device may randomly generate M, or the electronic device may acquire configured M. Any initial cluster center is a cluster center of an initial cluster. A manner of obtaining any initial cluster center is not limited in all embodiments of the present disclosure. For example, the electronic device may acquire M initial cluster centers inputted by the user, or the electronic device may randomly generate M initial cluster centers.

Then, based on the M initial cluster centers, the plurality of first initial values can be clustered into M initial clusters. In some embodiments, for any first initial value, distances between the first initial value and the initial cluster centers can be calculated. A manner of determining the distances is not limited in all embodiments of the present disclosure. For example, any distance determination manner of a Euclidean distance, a Manhattan distance, a Chebyshev distance, and the like may be used. The smallest distance can be determined from the distances between the first initial value and the initial cluster centers, and the first initial value can be classified into an initial cluster to which an initial cluster center corresponding to the smallest distance belongs. In this manner, the first initial values may be classified into the M initial clusters.

Next, for the respective initial cluster, a cluster center of the initial cluster can be re-determined based on the first initial values included in the initial cluster. For convenience of differentiation, the re-determined cluster center is referred to as a first cluster center. When a difference between an initial cluster center of the initial cluster and the first cluster center of the initial cluster is less than a first threshold (for example, the first threshold is 0 or 0.0001), the cluster center of the initial cluster remains unchanged. In contrast, when the difference between the initial cluster center of the initial cluster and the first cluster center of the initial cluster is not less than the first threshold, the cluster center of the initial cluster has changed.

If none of cluster centers of the M initial clusters has changed, the algorithm converges. In this case, the initial clusters can be used as the target clusters.

If a cluster center of at least one initial cluster of the M initial clusters has changed, the algorithm does not converge. In this case, the first cluster center is a cluster center of a first cluster, and the plurality of first initial values may be clustered into M first clusters based on M first cluster centers. For the respective first initial value, distances between the first initial value and the first cluster centers can be calculated, the smallest distance can be determined from the distances between the first initial value and the first cluster centers, and the first initial value can be classified into an initial cluster to which a first cluster center corresponding to the smallest distance belongs. In this manner, the first initial values may be classified into the M first clusters. Subsequently, for the respective first cluster, a cluster center of the first cluster can be re-determined based on the first initial values included in the first cluster. For convenience of differentiation, the re-determined cluster center is referred to as a second cluster center. When a difference between the first cluster center of the first cluster and the second cluster center of the first cluster is less than the first threshold, the cluster center of the first cluster remains unchanged. In contrast, when the difference between the first cluster center of the first cluster and the second cluster center of the first cluster is not less than the first threshold, the cluster center of the first cluster has changed.

If none of cluster centers of the M first clusters has changed, the algorithm converges. In this case, the first clusters can be used as the target clusters.

If a cluster center of at least one first cluster of the M first clusters has changed, the algorithm does not converge. In this case, the second cluster center is a cluster center of a second cluster, and the plurality of first initial values may be clustered into M second clusters based on M second cluster centers. An implementation of clustering the plurality of first initial values into M second clusters is similar to the implementations of "clustering the plurality of first initial values into the M initial clusters" and "clustering the plurality of first initial values into the M first clusters" described above. Through the implementation similar to the foregoing content, the plurality of first initial values can keep being clustered until the algorithm converges and M target clusters are obtained.

In brief, the clustering the plurality of first initial values by using the K-means clustering algorithm is equivalent to that according to a distance (for example, a Euclidean distance, a Manhattan distance, or a Chebyshev distance) between every two first initial values, the plurality of first initial values can be classified into M clusters, to minimize a distance between any two first initial values that belong to the same cluster and maximize a distance between any two first initial values that belong to different clusters. When cluster centers of the M clusters no longer change, the K-means clustering algorithm converges, to eventually obtain the M clusters. The M clusters are the M target clusters discussed above.

In some embodiments, the K-means clustering algorithm converges, which is equivalent to minimizing a square error. In some embodiments, the square error can be determined according to the following Formula (1).

$$error = \sum_{i=1}^{M} \sum_{x \in C_i} |x - \mu_i|^2$$

$$\mu_i = \frac{1}{|C_i|} \sum_{x \in C_i} x \quad \text{Formula (1)}$$

error represents the square error, M represents a quantity of cluster centers, $C_i$ represents an $i^{th}$ cluster center, x represents a first initial value in $C_i$, $\mu_i$ represents a cluster center of $C_i$, and $|C_i|$ represents a quantity of first initial values in $C_i$.

As can be learned from Formula (1), the square error represents a square of a distance between each first initial value and a cluster center of a cluster. The square error can be minimized by adjusting the cluster center continuously, so that the K-means clustering algorithm converges, to eventually obtain the M target clusters.

Operation 2013: select at least one first initial value from the respective target cluster as the first reference values, and determine the first initial values other than the selected at least one first initial value in the respective target cluster as the first candidate values.

In all embodiments of the present disclosure, at least one first initial value may be randomly selected from the first initial values included in the respective target cluster as the first reference values. Alternatively, the cluster center of the target cluster may be re-determined based on the first initial values included in any target cluster. For convenience of description, the re-determined cluster center of the target cluster is referred to as a target cluster center. Distances between first initial values in the respective target cluster and a target cluster center of the target cluster can be calculated. At least one distance not greater than a second threshold can be determined from the distances between the first initial values in the respective target cluster and the target cluster center of the target cluster. First initial values corresponding to distances not greater than the second threshold can be determined as the first reference values. One or more first initial values can be selected from first initial values included in the respective target cluster as the first reference values. In other words, at least one first reference value can be determined from the first initial values included in the respective target cluster.

The second threshold is not limited in all embodiments of the present disclosure. For example, the second threshold can be a value determined empirically, or the second threshold can be the smallest value in the distances between the first initial values in the target cluster and the target cluster center of the target cluster. When the second threshold is the smallest value in the distances between the first initial values in the target cluster and the target cluster center of the target cluster, one first reference value may be determined based on one target cluster, and the first reference value is a first initial value closest to a target cluster center in the target cluster.

In some embodiments, a manner of selecting the at least one first initial value from the respective target clusters as the first reference values may be: calculating distances between first initial values in the respective target cluster and a target cluster center of the target cluster, and determining at least one distance not less than a third threshold from the distances between the first initial values in the respective target cluster and the target cluster center of the target cluster. First initial values corresponding to distances not less than the third threshold can be determined as the first reference values. For example, the third threshold is a value determined empirically, or the third threshold is the largest value in the distances between the first initial values in the target cluster and the target cluster center of the target cluster. When the third threshold is the largest value in the distances between the first initial values in the target cluster and the target cluster center of the target cluster, one first reference value may be determined based on one target cluster, and the first reference value is a first initial value farthest from a target cluster center in the target cluster.

In the foregoing manner, the first reference values may be determined from the first initial values included in the target clusters. Next, the first initial values other than the determined first reference values in the target clusters can be determined as the first candidate values. The first reference values can be determined in a clustering manner, to improve the accuracy of the first reference values, so that the efficiency of determining a target value can be increased.

Operation 202: Perform a first quality detection on an original layout using the quality detection tool and based on the first reference values to obtain a first quality indicator set comprising one or more first quality indicators. In all embodiments of the present disclosure, the first quality indicator set or one or more first quality indicators can correspond to the first reference values.

Because the quality detection tool can support a quality detection of layouts, the quality detection tool may be determined by making the target parameter include respective first reference value, an original layout can be inputted into the quality detection tool, and the quality detection tool can perform a quality detection on the original layout to obtain a first quality indicator of the original layout corresponding to the first reference value. The original layout can be a layout that meets a layout quality standard specified in the field of chips, and can include, but not limited to, a chip layout, a mask layout, and a wafer layout. Because the target parameter includes the plurality of first reference values, a result of performing the quality detection on the original layout includes the first quality indicators of original layouts corresponding to the first reference values. The first quality indicator corresponding to the first reference value in this embodiment of this application is the quality indicator of the original layout corresponding to the first reference value.

For the respective first reference value of the plurality of first reference values, the first quality indicator of the original layout corresponding to the first reference value is configured to describe the quality of the original layout determined by using the quality detection tool in a case that the target parameter of the quality detection tool includes the first reference value.

Various types of indicators can be configured to describe the quality of the original layout. To be specific, in all embodiments of the present disclosure, the respective first reference value corresponds to at least one first quality indicator, the respective first quality indicator corresponding to the first reference value can be configured to describe the quality of the original layout in an aspect determined by using the quality detection tool in a case that the target parameter of the quality detection tool includes the first reference value. Two first quality indicators corresponding to the respective first reference value can describe quality of the original layout in different aspects.

For example, a mask complexity of the original layout may reflect the quality of the original layout. Generally, when the mask complexity of the original layout is lower, the quality of the original layout is higher. Therefore, the respective first quality indicator corresponding to the respective first reference value may be a mask complexity corresponding to the first reference value. The quality of the original layout is described through the mask complexity. The mask complexity corresponding to the first reference value is negatively correlated with the original layout. To be specific, when the mask complexity corresponding to the first reference value is smaller, the quality of the original layout is higher.

**In** another example, an edge distance error of the original layout may reflect the quality of the original layout. Generally, when the edge distance error of the original layout is lower, the quality of the original layout is higher. Therefore, the respective first quality indicator corresponding to the respective first reference value may be an edge distance error corresponding to the first reference value. The quality of the original layout can be described through the edge distance error. The edge distance error corresponding to the first reference value is negatively correlated with the original layout. To be specific, when the edge distance error corresponding to the first reference value is smaller, the quality of the original layout is higher.

**In** a possible implementation, Operation 202 can include: processing the original layout according to the plurality of first reference values by using the quality detection tool to obtain predicted layouts corresponding to the first reference values, and determining the first quality indicator set corresponding to the first reference values based on the predicted layouts corresponding to the first reference values.

**In** all embodiments of the present disclosure, in a case that the target parameter includes the respective first reference value, the original layout can be inputted into the quality detection tool, and the quality detection tool can process the original layout to obtain a predicted layout corresponding to the first reference value. In some embodiments, the quality detection tool can include a photoresist model. The photoresist model may simulate a photolithography device in an actual scenario to perform photolithography on the original layout to obtain the predicted layout.

In other words, if the original layout may be a chip layout, the quality detection tool can perform photolithography on the chip layout. To be specific, the quality detection tool can simulate a process of the photolithography device performing photolithography on a mask based on the chip layout to obtain a mask layout, and the mask layout is the predicted layout. If the original layout is a mask layout, or the original layout is a chip layout and the quality detection tool obtains a mask layout based on the chip layout, the quality detection tool may perform photolithography on the mask layout. To be specific, the quality detection tool can simulate a process of the photolithography device performing photolithography on a wafer based on the mask layout to obtain a wafer layout, and the wafer layout can be the predicted layout.

In all embodiments of the present disclosure, for the respective first reference value, the quality detection tool may analyze a pattern of a predicted layout corresponding to the respective first reference value, and an analysis result can be used as the first quality indicator of the original layout corresponding to the first reference value. Because of an interference effect and a diffraction effect in the process of photolithography, an error exists in the pattern of the predicted layout, so that the quality detection tool can analyze quality of the predicted layout based on the pattern of the predicted layout to obtain an analysis result. The analysis result can reflect the quality of the original layout and can reflect the quality of the predicted layout. A manner of analyzing the pattern by the quality detection tool is not limited in all embodiments of the present disclosure.

In some embodiments, if the original layout is a chip layout and the predicted layout is a wafer layout, for the respective first reference value, the quality detection tool can determine an error between the original layout and the predicted layout corresponding to the first reference value. In some embodiments, pixels in the predicted layout can correspond one-to-one to pixels in the original layout. In other words, the respective pixel in the predicted layout can have a corresponding pixel in the original layout. The quality detection tool can determine pixel differences between the pixels in the predicted layout and corresponding pixels in the original layout, and a sum value, an average value, or the like of these pixel differences can be determined as the error between the predicted layout and the original layout. Alternatively, the quality detection tool can extract a feature of the predicted layout and a feature of the original layout, and use a feature distance between the feature of the predicted layout and the feature of the original layout as the error between the predicted layout and the original layout.

Next, based on the error between the original layout and the predicted layout corresponding to the respective first reference value, the first quality indicator of the original layout corresponding to the first reference value (i.e., the first quality indicator corresponding to the first reference value) can be determined. For example, the error between the original layout and the predicted layout corresponding to the respective first reference value can be used as the first quality indicator of the original layout corresponding to the first reference value, or the error between the original layout and the predicted layout corresponding to the respective first reference value can be weighted to obtain the first quality indicator of the original layout corresponding to the first reference value.

Theoretically, if the accuracy of the quality detection tool is 100%, the error between the predicted layout and the original layout is 0, and if the accuracy of the quality detection tool is 0, the error between the predicted layout and the original layout is 100%. Therefore, when the quality detection tool is more accurate, the error between the predicted layout and the original layout is smaller. In other words, the error between the predicted layout and the original layout may reflect the accuracy of the quality detection tool. The first quality indicators of the original layouts corresponding to the first reference values can be calculated through errors between the original layout and the predicted layouts corresponding to the first reference values, so that the first quality indicators of the original layouts corresponding to the first reference values can also reflect the accuracy of the quality detection tool. In this way, a value of the parameter of the quality detection tool can be adjusted to be more accurate based on the first quality indicators of the original layouts corresponding to the first reference values, thereby ensuring the accuracy of the quality detection tool.

In addition, the quality detection tool can directly determine the quality indicators of the original layouts based on the original layouts without simulating a photolithography device in an actual scenario. In other words, in a case that the target parameter can include the respective first reference value, the quality detection tool may analyze a pattern of an original layout to obtain a first quality indicator of the original layout corresponding to the first reference value. A manner of analyzing the pattern of the original layout by the quality detection tool is not limited in all embodiments of the present disclosure.

Operation 203: In a case that the first quality indicator set does not meet a pre-defined quality condition, select a first target candidate value from the first candidate values based on the first quality indicator set, and determine, for the target parameter, a plurality of second reference values based on the first reference values and the first target candidate value. In all embodiments of the present disclosure, the first quality indicator set can correspond to the first reference values

That the first quality indicators corresponding to the first reference values do not meet a pre-defined quality condition may be that a first quality indicator corresponding to at least one first reference value of the first reference values does not meet the pre-defined quality condition. To be specific, that the first quality indicators corresponding to the first reference values do not meet a pre-defined quality condition may be that first quality indicators corresponding to some first reference values or all first reference values of the first reference values do not meet the pre-defined quality condition. That a first quality indicator corresponding to the respective first reference value does not meet the pre-defined quality condition is not limited in all embodiments of the present disclosure. For example, it may be determined, based on a first quality indicator corresponding to the respective first reference value and a reference threshold, whether the first quality indicator corresponding to the first reference value meets the pre-defined quality condition. The reference threshold can be set empirically, or can be flexibly adjusted according to an application scenario. This is not limited in all embodiments of the present disclosure.

In some embodiments, if the quality indicator is negatively correlated with the quality of the original layout, for example, the quality indicator is a mask complexity, an edge distance error, or the like, when a first quality indicator corresponding to the respective first reference value is greater than the reference threshold, it can be determined that a first quality indicator corresponding to the respective first reference value does not meet the pre-defined quality condition; and when a first quality indicator corresponding to the respective first reference value is not greater than the reference threshold, it can be determined that a first quality indicator corresponding to the respective first reference value meets the pre-defined quality condition. If the quality indicator is positively correlated with the quality of the original layout, when a first quality indicator corresponding to the respective first reference value is less than the reference threshold, it can be determined that a first quality indicator corresponding to the respective first reference value does not meet the pre-defined quality condition; and when a first quality indicator corresponding to the respective first reference value is not less than the reference threshold, it can be determined that a first quality indicator corresponding to the respective first reference value meets the pre-defined quality condition.

Alternatively, the first quality indicators corresponding to the first reference values can be determined in an iterative calculation manner. A quantity of iterations for determining the first quality indicators corresponding to the first reference values may be acquired. If the quantity of iterations is less than a quantity threshold, it can be determined that the first quality indicators corresponding to the first reference values do not meet the pre-defined quality condition. If the quantity of iterations is not less than the quantity threshold, it can be determined that the first quality indicators corresponding to the first reference values meet the pre-defined quality condition. The quantity threshold can be set empirically, or can be flexibly adjusted according to an application scenario. This is not limited in all embodiments of the present disclosure.

In all embodiments of the present disclosure, a quantity of the first reference values is M, and a quantity of the first candidate values is L-M. First quality indicators corresponding to the M first reference values may be sequentially denoted as $(y_1, ..., y_m, ..., y_M)$. In a case that a first quality indicator in $(y_1, ..., y_m, ..., y_M)$ does not meet the pre-defined quality condition, the first target candidate value may be determined from the L-M first candidate values based on $(y_1, ..., y_m, ..., y_M)$. M is an integer greater than 1, and L-M is an integer greater than 1.

In a possible implementation, the "selecting a first target candidate value from the plurality of first candidate values based on the first quality indicator set corresponding to the first reference values" in Operation 203 can include Operation 2031 and Operation 2032 (not shown in the figure). One first target candidate value may be used, or a plurality of first target candidate values may be used. In other words, at least one first target candidate value can be used. To be specific, at least one first target candidate value can be determined from the plurality of first candidate values based on the first quality indicator set corresponding to the first reference values, and the plurality of second reference values of the target parameter can be determined based on the plurality of first reference values and the at least one first target candidate value.

Operation 2031: Determine at least one evaluation indicator for the respective first candidate value based on at least one first quality indicator corresponding to the respective first reference value, the at least one evaluation indicator for the respective first candidate value being configured to describe a possibility that a quality indicator meets the pre-defined quality condition when a quality detection is performed on the original layout using the quality detection tool in a case that the target parameter includes the respective first candidate value.

In all embodiments of the present disclosure, the first quality indicators corresponding to the first reference values may be denoted as $(y_1, ..., y_m, ..., y_M)$. Evaluation indicators of the L-M first candidate values can be determined based on $(y_1, ..., y_m, ..., y_M)$. In some embodiments, the at least one evaluation indicator for the respective first candidate value may be an expected improvement (EI) value. The expected improvement value reflects an improvement of the accuracy of the quality detection tool in a case that the target parameter includes the first candidate value.

When a quality detection can be performed on the original layout by using the quality detection tool, the quality indicator of the original layout may be obtained, and the quality indicator of the original layout can reflect the accuracy of the quality detection tool. When the quality indicator is closer to the pre-defined quality condition, the accuracy of the quality detection tool can be better improved. Therefore, an expected improvement of the respective first candidate value may reflect a possibility that a quality indicator meets the pre-defined quality condition when a quality detection can be performed on the original layout by using the quality detection tool in a case that the target parameter includes the first candidate value. When the expected improvement value of the respective first candidate value is larger, the possibility is higher.

In some embodiments, Operation 2031 can include Operation S1 and Operation S2 (not shown in the figure).

Operation S1: Determine a first mapping relationship based on the respective first reference value and the at least one first quality indicator corresponding to the respective first reference value, the first mapping relationship being configured to describe a mapping relationship between the respective first reference value and statistical information of a statistical distribution in a case that the at least one quality indicators corresponding to the respective first reference values meets the statistical distribution.

In all embodiments of the present disclosure, the first mapping relationship may be determined based on the M first reference values and the first quality indicators $(y_1, ..., y_m, ..., y_M)$ corresponding to the M first reference values. $(y_1, ..., y_m, ..., y_M)$, wherein the first quality indicators $(y_1, ..., y_m, ..., y_M)$ meet a statistical distribution. The first mapping relationship can be configured to describe a mapping relationship between the M first reference values and the statistical information of the statistical distribution.

The statistical distribution is not limited in all embodiments of the present disclosure. For example, the statistical distribution is a Gaussian distribution, a chi-squared distribution, an F distribution, or the like. Different statistical distributions correspond to different statistical information. The statistical information is a parameter configured to determine a statistical distribution. For example, statistical information of a Gaussian distribution can include a mean value and a variance.

In some embodiments, M Gaussian process (GP) regression models may be determined based on the M first reference values and the first quality indicators $(y_1, ..., y_m, ..., y_M)$ corresponding to the M first reference values. An $m^{th}$ Gaussian process regression model can be configured to describe a mapping relationship between an $m^{th}$ first reference value and a mean value and a variance of a Gaussian distribution in a case that a first quality indicator $y_m$ corresponding to the $m^{th}$ first reference value meets the Gaussian distribution. In this case, the first mapping relationship can be described through the M Gaussian process regression models.

For the $m^{th}$ Gaussian process regression model, because the mean value and the variance of the Gaussian distribution may reflect $y_m$, the $m^{th}$ Gaussian process regression model may reflect a mapping relationship between the $m^{th}$ first reference value and the corresponding first quality indicator $y_m$. $y_m$ can be described through a Gaussian process algorithm, and the $m^{th}$ Gaussian process regression model can be obtained. The model may be represented as: $GP(\mu_m(x), \sigma_m(x))$. $x$ represents the target parameter, GP represents the Gaussian distribution that the corresponding quality indicator $y_m$ meets when the target parameter is the $m^{th}$ first reference value, $\mu_m(x)$ is the mean value of the Gaussian distribution, and $\sigma_m(x)$ is the variance of the Gaussian distribution. In some embodiments, the variance of the Gaussian distribution is also referred to as an uncertainty of the Gaussian distribution.

In some embodiments, the Gaussian process regression model may describe root mean square errors of the first quality indicators corresponding to the first reference values, to be specific, $Error(x) \sim GP(m(x), k(x, x'))$. $Error(x)$ represents the mean square errors of the corresponding quality indicators when the target parameter $x$ includes the first reference values, $m(x)$ is a mean value function of the target parameter $x$, and $k(x, x')$ is a kernel function related to the target parameter $x$ and another parameter $x'$ other than the target parameter $x$ in the quality detection tool. In all embodiments of the present disclosure, an n-dimensional square exponential function can be used as the kernel function, and the kernel function may be denoted as: $k(x, x') =$

$$\exp\left\{-\frac{\Sigma_{i=1}^{n}\left|x_i - x_i'\right|^2}{\sigma_i^2}\right\}$$

. exp represents an exponential function with the natural constant e as the base, $\Sigma$ is a summation symbol, $x_i$ represents an $i^{th}$ first reference value of the target parameter $x$, $x_i'$ represents an $i^{th}$ value of another parameter, $n$ is a dimension of $x$, and $\sigma_i^2$ is a hyperparameter obtained through maximum-likelihood estimation.

The first mapping relationship may be described through the M Gaussian process regression models. The M Gaussian process regression models can be a set the meets a joint Gaussian distribution. In other words, on the premise that the first quality indicators corresponding to the first reference values can meet the Gaussian distribution, the Gaussian process regression models corresponding to the first reference values can be determined, to determine the first mapping relationship.

Operation S2: For the respective first candidate value, determine statistical information corresponding to the respective first candidate value based on the respective first candidate value and the first mapping relationship, and determine the at least one evaluation indicator for the respective first candidate value based on the statistical information corresponding to the respective first candidate value.

In all embodiments of the present disclosure, the first mapping relationship can reflect a mapping relationship between the first reference values and statistical information. In other words, the first mapping relationship may map the respective first reference value into corresponding statistical information. Based on this, through the first mapping relationship, the respective first candidate value may be mapped into statistical information corresponding to the respective first candidate value.

Next, at least one evaluation indicator of the respective first candidate value can be calculated by using the statistical information corresponding to the respective first candidate value. In all embodiments of the present disclosure, a calculation manner of the evaluation indicator of the first candidate value is not limited. For example, the statistical information corresponding to the first candidate value can be weighted to obtain the evaluation indicator of the first candidate value, or the evaluation indicator of the first candidate value can be determined according to Operation S21 to Operation S23 discussed below.

In some embodiments, the statistical information corresponding to the respective first candidate value can include a mean value and a variance. In some embodiments, the first mapping relationship can include a Gaussian process regression model. As can be learned from the foregoing description of the model, the model may predict a first candidate value to obtain a mean value $\mu_m(x)$ and a variance $\sigma_m(x)$ corresponding to the first candidate value. In this case, the "determining the at least one evaluation indicator of the respective first candidate value based on the statistical information corresponding to the respective first candidate value" in Operation S2 can include Operation S21 to Operation S23 (not shown in the figure).

Operation S21: Determine a reference quality indicator from the at least one first quality indicator corresponding to the respective first reference values.

In all embodiments of the present disclosure, one first quality indicator can be randomly determined from the first quality indicators corresponding to the first reference values, or the reference quality indicator can be determined according to Implementation A1 or Implementation A2 discussed below.

In Implementation A1, the respective first reference value can correspond to one first quality indicator. In this case, Operation S21 can include: determining the smallest quality indicator from the at least one first quality indicator corresponding to the first reference value, and determining the smallest quality indicator as the reference quality indicator.

In all embodiments of the present disclosure, for single-target minimization optimization, one quality indicator can be configured to describe an original layout. In this case, one first reference value can correspond to one first quality indicator. For example, the quality indicator of the original layout can be a mask complexity of the original layout, and one first reference value can correspond to one mask complexity. The single-target minimization optimization is optimizing a quality indicator corresponding to an aspect obtained when the quality detection tool performs a quality detection on the original layout in the aspect. In other words, the single-target minimization optimization is optimizing a single quality indicator in the quality detection tool.

Based on this, the M first reference values can correspond to M first quality indicators, which are respectively $(y_1, ..., y_m, ..., y_M)$. The smallest quality indicator may be determined from the first quality indicators corresponding to the first reference values, and the smallest quality indicator can be determined as the reference quality indicator. To be specific, the reference quality indicator can be $f_m = \min(y_1, ..., y_m, ..., Y_M)$.

In Implementation A2, the respective first reference value can correspond to a plurality of quality indicators. In this case, Operation S21 can include Operation S211 to Operation S213 (not shown in the figure).

In all embodiments of the present disclosure, for multiple-target minimization optimization, a plurality of quality indicators can be configured to describe an original layout. In this case, one first reference value can correspond to a plurality of first quality indicators. For example, the quality indicator of the original layout can include a mask complexity of the original layout and an edge distance error of the original layout, and one first reference value can correspond to one mask complexity and one edge distance error. The multiple-target minimization optimization is optimizing a quality indicator corresponding to a plurality of aspects obtained when the quality detection tool can perform a quality detection on the original layout in the aspects. In other words, the multiple-target minimization optimization is optimizing a plurality of quality indicators in the quality detection tool.

The quality detection tool can have a large number of adjustable parameters. These adjustable parameters can affect a quality detection result of a layout. Generally, a plurality of quality indicators are configured to represent layout quality, and a balance relationship exists between the quality indicators. For example, when a mask error is smaller, a mask complexity is higher, and manufacturing difficulty is higher. Therefore, the mask complexity and the mask error can balance out each other. A Pareto effect can be formed between the mask complexity and the mask error, and a Pareto optimal solution set needs to be determined. In some embodiments, the Pareto optimal solution set is also referred to as a Pareto front. When the focus can be on a quality indicator, a solution inclining toward the quality indicator on the Pareto front may be determined.

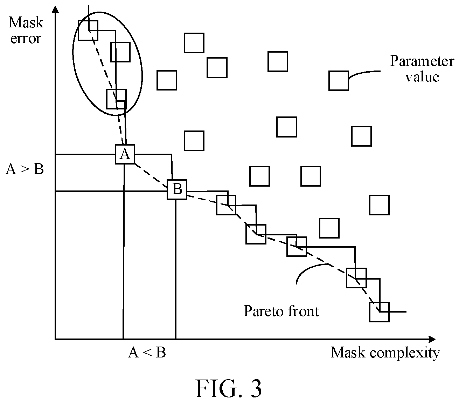

FIG. 3 is a schematic diagram of a Pareto front between a mask error and a mask complexity according to an embodiment of this application. As can be learned from FIG. 3, on the Pareto front, if a mask error A is greater than a mask error B, a mask complexity A is less than a mask complexity B. A and B are data on the Pareto front. The data can include a mask error and a mask complexity. When more focus is on the mask error, data (that is, parameter values enclosed by the ellipse in FIG. 3) inclining toward the mask error on the Pareto front may be determined.

Operation S211: For the respective first quality indicator of the plurality of first quality indicators, determine a maximum value and a minimum value of the respective first quality indicator from the respective first quality indicators corresponding to the respective first reference values.

In all embodiments of the present disclosure, assuming that a total of M (M is a positive integer)) first quality indicators can be used, each first reference value can correspond to M first quality indicators. An example in which any first reference value is the $i^{th}$ first reference value and the respective (any) first quality indicator is an $m^{th}$ quality indicator is used, and the $m^{th}$ first quality indicator corresponding to the $i^{th}$ first reference value may be denoted as $y_{m,i}$. A maximum value $y_m^{\max}$ of the $m^{th}$ first quality indicator and a minimum value $y_m^{\min}$ of the $m^{th}$ first quality indicator may be determined from the $m^{th}$ first quality indicators corresponding to the first reference values.

Operation S212: For the respective quality indicator corresponding to the respective first reference value, determine a priority indicator of the respective first quality indicator corresponding to the respective first reference value based on a first selected quality indicator, a weight of the first selected quality indicator, and the maximum value and the minimum value of the first selected quality indicator, the first selected quality indicator being at least one of the plurality of first quality indicators corresponding to the respective first reference value, the first selected quality indicator including the respective first quality indicator corresponding to the respective first reference value.

In all embodiments of the present disclosure, the electronic device may acquire a weight of any first quality indicator. The weight can be configured to describe the importance of the first quality indicator. In other words, when the weight of any quality indicator is larger, the first quality indicator is more important, and can better reflect the quality of the original layout. A manner of acquiring the weight of any first quality indicator is not limited in all embodiments of the present disclosure. For example, the electronic device may acquire a weight of any inputted first quality indicator, or the electronic device may determine a weight of any first quality indicator according to a quantity of first quality indicators. For example, two first quality indicators can be used, and a weight of each first quality indicator can be 0.5.

In some embodiments, the first quality indicators can be sorted to obtain the sorted first quality indicators. For example, the first quality indicators may be sorted in a manual sorting manner, or the first quality indicators may be sorted in a random sorting manner. When a priority indicator of the respective first quality indicator corresponding to the respective first reference value can be calculated, calculation may be performed by using the first quality indicator and the first quality indicators sorted following the first quality indicator. The first quality indicators used to calculate the first priority indicator of the respective quality indicator corresponding to the respective first reference value are referred to as first selected quality indicators. In other words, for the first selected quality indicator (i.e., at least one first quality indicator of the plurality of first quality indicators corresponding to the respective first reference value) in Operation S212, when any first quality indicator corresponding to any first reference value is the last quality indicator after sorting, the first selected quality indicator (i.e., at least one first quality indicator of the plurality of first quality indicators corresponding to any first reference value) can include any first quality indicator corresponding to any first reference value. When any first quality indicator corresponding to any first reference value is not the last first quality indicator after sorting, the first selected quality indicator (i.e., at least one first quality indicator of the plurality of first quality indicators corresponding to any first reference value) can include any first quality indicator corresponding to any first reference value and first quality indicators sorted following any first quality indicator corresponding to any first reference value.

Assuming that each first reference value can correspond to M first quality indicators, an example in which the respective first reference value is the $i^{th}$ first reference value and the respective first quality indicator is an $m^{th}$ quality indicator can be used, and at least one first quality indicator in a plurality of first quality indicators corresponding to the $i^{th}$ first reference value can include an $m^{th}$ to an $M^{th}$ first quality indicators corresponding to the $i^{th}$ first reference value.

In all embodiments of the present disclosure, the electronic device may determine a priority indicator of the $m^{th}$ first quality indicator corresponding to the $i^{th}$ first reference value according to the following Formula (2).

$$d_i = \sum_m^M \omega_m \frac{y_{m,i} - y_m^{max}}{y_m^{max} - y_m^{min}} \quad \text{Formula (2)}$$

$d_i$ represents the priority indicator of the $m^{th}$ first quality indicator corresponding to the $i^{th}$ first reference value. M represents the quantity of first quality indicators. $\omega_m$ represents a weight of the $m^{th}$ first quality indicator, $y_{m,i}$ represents the $m^{th}$ first quality indicator corresponding to the $i^{th}$ first reference value, $y_m^{max}$ represents the maximum value of the $m^{th}$ first quality indicator, and $y_m^{min}$ represents the minimum value of the $m^{th}$ first quality indicator.

In Formula (2), when the priority indicator of the $m^{th}$ first quality indicator corresponding to the $i^{th}$ first reference value can be determined, the $m^{th}$ to the $M^{th}$ first quality indicators corresponding to the $i^{th}$ first reference value need to be used. As can be learned, Formula (2) is about the priority indicator of the $m^{th}$ first quality indicator corresponding to the $i^{th}$ first reference value determined on the premise that the M first quality indicators can balance out each other, thereby improving the accuracy of the priority of the first quality indicator. When the reference quality indicator can be determined based on the priority indicator of the first quality indicator in Operation S213, the reference quality indicator can approximate to a Pareto optimal solution of the M first quality indicators, thereby improving the accuracy of the reference quality indicator.

In some embodiments, after the first quality indicators are sorted, when a priority indicator of the respective first quality indicator corresponding to the respective first reference value can be calculated, calculation may be performed by using the respective first quality indicator and first quality indicators sorted before the respective first quality indicator. In other words, for the first selected quality indicator (i.e., at least one first quality indicator of the plurality of first quality indicators corresponding to the respective first reference value) in Operation S212, when the respective first quality indicator corresponding to the respective first reference value is the $1^{st}$ first quality indicator after sorting, the first selected quality indicator (i.e., at least one first quality indicator of the plurality of first quality indicators corresponding to the respective first reference value) can include the respective first quality indicator corresponding to the respective first reference value. When the respective first quality indicator corresponding to the respective first reference value is not the $1^{st}$ first quality indicator after sorting, the first selected quality indicator (i.e., at least one first quality indicator of the plurality of first quality indicators corresponding to the respective first reference value) can include the respective first quality indicator corresponding to the respective first reference value and the first quality indicators sorted before the respective first quality indicator corresponding to the respective first reference value.

Assuming that each first reference value can correspond to M first quality indicators, an example in which the respective first reference value is the $i^{th}$ first reference value and the respective quality indicator is an $m^{th}$ first quality indicator can be used, and at least one first quality indicator in a plurality of first quality indicators corresponding to the $i^{th}$ first reference value can include the first to the $m^{th}$ first quality indicators corresponding to the $i^{th}$ first reference value.

Operation S213: Determine the reference quality indicator from the respective first quality indicator corresponding to the respective first reference values based on priority indicators of the respective first quality indicators corresponding to the respective first reference values.

In all embodiments of the present disclosure, the priority indicators of the respective first quality indicators corresponding to the respective first reference values may be determined in the manner in Operation S212. Next, the smallest priority indicator can be selected from these first priority indicators, and a first quality indicator corresponding to the smallest priority indicator can be determined as the reference quality indicator. In other words, the reference quality indicator $f_m$ is a first quality indicator corresponding to the smallest $d_i$. Alternatively, a priority indicator not greater than a priority threshold can be selected from these priority indicators, and a first quality indicator corresponding to the priority indicator not greater than the priority threshold can be determined as the reference quality indicator. In this manner, the reference quality indicator can be determined from the first quality indicators corresponding to the first reference values.

For example, the first quality indicators corresponding to the first reference values can be used as a training set, and the reference quality indicator $f_m$ determined in Implementation A2 can be an evaluation result corresponding to the most balanced parameter of a Pareto front of the training set. The Pareto front can be calculated in the training set, and a weighted Euclidean distance $d_i$ can be calculated on the Pareto front. The reference quality indicator $f_m$ can be determined through $d_i$, so that the accuracy of $f_m$ can be improved, thereby improving the accuracy of the evaluation indicator of the first candidate value.

Operation S22: Determine a normal distribution function corresponding to the respective first candidate value based on the reference quality indicator and the mean value and the variance corresponding to the respective first candidate value.

In all embodiments of the present disclosure, a difference between the reference quality indicator and the mean value corresponding to the respective first candidate value may be determined; and a quotient of the difference by the variance corresponding to the respective first candidate value may be used as the normal distribution function corresponding to the respective first candidate value. In other words, the difference between the reference quality indicator and the mean value corresponding to the respective first candidate value may be divided by the variance corresponding to the respective first candidate value to obtain the normal distribution function corresponding to the respective first candidate value. In some embodiments, a normal distribution function $z_m$ corresponding to the respective first candidate value may be represented as: $z_m = (f_m - \mu_m(x))/\sigma_m(x)$. $f_m$ is the reference quality indicator, $\mu_m(x)$ is the mean value corresponding to the respective first candidate value, and $\sigma_m(x)$ is the variance corresponding to the respective first candidate value.

Operation S23: Determine the at least one evaluation indicator for the respective first candidate value based on the variance corresponding to the respective first candidate value, the normal distribution function corresponding to the respective first candidate value, and a cumulative density function and a probability density function of the normal distribution function corresponding to the respective first candidate value.

In all embodiments of the present disclosure, the normal distribution function corresponding to the respective first candidate value may be multiplied by the cumulative density function of the normal distribution function corresponding to the respective first candidate value to obtain a multiplication result. The multiplication result can be added to the probability density function of the normal distribution function corresponding to the respective first candidate value to obtain an addition result. The addition result can be multiplied by the variance corresponding to the respective first candidate value to obtain the at least one evaluation indicator for the respective first candidate value. In some embodiments, an evaluation indicator $EI_m(x)$ of the respective first candidate value may be represented as: $EI_m(x) = \sigma_m(x)[z_m\Phi(z_m) + \Phi(z_m)]$. $\sigma_m(x)$ represents the variance corresponding to the respective first candidate value, $z_m$ represents the normal distribution function corresponding to the respective first candidate value, $\Phi(z_m)$ represents the cumulative density function of $z_m$, and $\Phi(z_m)$ represents the probability density function of $z_m$.

The evaluation indicator $EI_m(x)$ of the respective first candidate value can include two items. The first item is $\sigma_m(x)z_m\Phi(z_m)$. The item tends to search for a result better than a current optimal value, representing performing a local search in a detection process. The second item is $\sigma_m(x)\Phi(z_m)$. The item tends to search for an area with a higher uncertainty in a space in which the first candidate value is located, representing performing a global search in the detection process. The evaluation indicator of the respective first candidate value can be determined through the first item and the second item, to implement the local search and the global search in the detection process, thereby improving the accuracy of the evaluation indicator of the first candidate value.

The evaluation indicator of the first candidate value can be determined by considering the statistical distribution and the statistical information, thereby ensuring the accuracy of the evaluation indicator of the first candidate value. In addition, in a process of determining the evaluation indicator of the first candidate value, in consideration of different cases that the first reference value corresponds to one or more first quality indicators, in the different cases, the evaluation indicator of the first candidate value can be determined in different manners, so that the reliability of the manners of determining the evaluation indicator of the first candidate value is high, to further ensure the accuracy of the evaluation indicator of the first candidate value, thereby improving the accuracy of the eventually determined target value.

Operation 2032: Determine the first target candidate value from the plurality of first candidate values based on the at least one evaluation indicator for the respective first candidate value.

In all embodiments of the present disclosure, in the manner in Operation 2031, the evaluation indicators of the first candidate values may be determined. For the respective first candidate value, it may be determined, based on the evaluation indicator of the respective first candidate value, whether the first candidate value may be used as the first target candidate value, to determine the first target candidate value from the plurality of first candidate values. In some embodiments, the first target candidate value can be determined according to Implementation B1 or Implementation B2 below. For example, at least one first target candidate value is used. To be specific, the at least one first target candidate value can be determined from the plurality of first candidate values based on the at least one evaluation indicator for the respective first candidate value.

In Implementation B1, the respective first candidate value corresponds to one evaluation indicator. In this case, Operation 2032 can include: selecting a first candidate value, which the evaluation indicator corresponding to is not less than a set indicator threshold, from the plurality of first candidate values based on the evaluation indicator corresponding to the respective first candidate values as the first target candidate value.

For single-target minimization optimization, one quality indicator can be used. According to the content related to the first mapping relationship in Operation S1, one first mapping relationship may be obtained. As can be learned from the content related to the evaluation indicator of the first candidate value in Operation S2, one first candidate value can correspond to one evaluation indicator.

For the respective first candidate value, if the evaluation indicator of the first candidate value is not less than the set indicator threshold, the first candidate value can be used as the first target candidate value; and if the evaluation indicator of the first candidate value is less than the set indicator threshold, the first candidate value can be not used as the first target candidate value. In this manner, the first target candidate value may be determined.

A manner of determining the set indicator threshold is not limited in all embodiments of the present disclosure. For example, the set indicator threshold is a value set empirically. Alternatively, the evaluation indicators of the first candidate values can be sorted in descending order or in ascending order to obtain sorted evaluation indicators. An Mth (the set quantity) evaluation indicator after sorting can be set as the set indicator threshold. In this case, it is equivalent to that a plurality of first candidate values can be sorted in descending order of evaluation indicators, and the first candidate values of the set quantity at the top can be selected as the first target candidate values; or it is equivalent to that a plurality of first candidate values can be sorted in ascending order of evaluation indicators, and an Mth (the set quantity) first candidate value and first candidate values following the Mth (the set quantity) first candidate value can be used as the first target candidate values.

In Implementation B2, the respective first candidate value can correspond to a plurality of evaluation indicators. In this case, Operation 2032 can include Operation 20321 to Operation 20324 (not shown in the figure).

For multiple-target minimization optimization, a plurality of quality indicators can be used. As can be learned from the content related to the first mapping relationship in Operation S1, each quality indicator corresponds to one first mapping relationship. As can be learned from the content related to the evaluation indicator of the first candidate value in Operation S2, one evaluation indicator corresponding to one first candidate value may be determined through one first mapping relationship. Based on this, one first candidate value corresponds to a plurality of evaluation indicators.

Operation 20321: For the respective evaluation indicator of the plurality of evaluation indicators, determine a maximum value and a minimum value of the respective evaluation indicator from the respective evaluation indicators corresponding to the respective first candidate value.

In all embodiments of the present disclosure, assuming that a total of M (M is a positive integer)) evaluation indicators are used, each first candidate value can correspond to the M evaluation indicators. An example in which the respective first candidate value is an $i^{th}$ first candidate value and the respective evaluation indicator is an $m^{th}$ evaluation indicator is used, and the $m^{th}$ evaluation indicator corresponding to the $i^{th}$ first candidate value may be denoted as $EI_{m,i}$. A maximum value $EI_m^{\max}$ of the $m^{th}$ evaluation indicator and a minimum value $EI_m^{\min}$ of the $m^{th}$ evaluation indicator may be determined from the $m^{th}$ evaluation indicators corresponding to the respective first candidate values.

Operation 20322: For the respective evaluation indicator corresponding to the respective first candidate value, determine a priority indicator of the respective evaluation indicator corresponding to the respective first candidate value based on a selected evaluation indicator and a maximum value and a minimum value of the selected evaluation indicator, the selected evaluation indicator being at least one of the plurality of evaluation indicators corresponding to the respective first candidate value, the selected evaluation indicator including the respective evaluation indicator corresponding to the respective first candidate value.

In some embodiments, the evaluation indicators can be sorted to obtain the sorted evaluation indicators. For example, the evaluation indicators may be sorted in a manual sorting manner, or the evaluation indicators may be sorted in a random sorting manner. When a priority indicator for the respective evaluation indicator corresponding to the respective first candidate value can be calculated, calculation may be performed by using the respective evaluation indicator and evaluation indicators sorted following the respective evaluation indicator. An evaluation indicator used to calculate the priority indicator for the respective evaluation indicator corresponding to the respective first candidate value is referred to as a selected evaluation indicator. In other words, for the selected evaluation indicator (i.e., at least one evaluation indicator of the plurality of evaluation indicators corresponding to the respective first candidate value) in Operation 20322, when the respective evaluation indicator corresponding to the respective first candidate value is the last evaluation indicator after sorting, the selected evaluation indicator (i.e., at least one evaluation indicator of the plurality of evaluation indicators corresponding to the respective first candidate value) can include the respective evaluation indicator corresponding to the respective first candidate value. When the respective evaluation indicator corresponding to the respective first candidate value is not the last evaluation indicator after sorting, the selected evaluation indicator (i.e., at least one evaluation indicator of the plurality of evaluation indicators corresponding to the respective first candidate value) can include the respective evaluation indicator corresponding to the respective first candidate value and evaluation indicators sorted following the respective evaluation indicator corresponding to the respective first candidate value.

Assuming that each first candidate value can correspond to M evaluation indicators, an example in which the respective first candidate value is an $i^{th}$ first candidate value and the respective evaluation indicator is an $m^{th}$ evaluation indicator is used, and at least one evaluation indicator in a plurality of evaluation indicators corresponding to the $i^{th}$ first candidate value can include the $m^{th}$ to an $M^{™}$ evaluation indicators corresponding to the $i^{th}$ first candidate value.

In all embodiments of the present disclosure, the electronic device may acquire a weight of the respective evaluation indicator. The weight can be configured to describe the importance of the evaluation indicator. In other words, when the weight of the respective evaluation indicator is larger, the evaluation indicator is more important. A manner of acquiring the weight of the respective evaluation indicator is not limited in all embodiments of the present disclosure. For example, the electronic device may acquire a weight of any inputted evaluation indicator, or the electronic device may determine a weight of the respective evaluation indicator according to a quantity of evaluation indicators. For example, two evaluation indicators can be used, and a weight of each evaluation indicator is 0.5.

In some embodiments, the electronic device may determine a priority indicator of the $m^{th}$ evaluation indicator corresponding to the $i^{th}$ first candidate value according to the following Formula (3).

$$d_i^{'} = \sum_m^M \omega_{M-m} \frac{EI_{m,i} - EI_m^{max}}{EI_m^{max} - EI_m^{min}} \quad \text{Formula (3)}$$

$d_i^{'}$ represents the priority indicator of the $m^{th}$ evaluation indicator corresponding to the $i^{th}$ first candidate value. M represents the quantity of evaluation indicators. $\omega_{M-m}$ represents a weight of the $(M-m)^{th}$ evaluation indicator, $EI_{m,i}$ represents the $m^{th}$ evaluation indicator corresponding to the $i^{th}$ first candidate value, $EI_m^{max}$ represents the maximum value of the $m^{th}$ evaluation indicator, and $EI_m^{min}$ represents the minimum value of the $m^{th}$ evaluation indicator.

In some embodiments, after the evaluation indicators are sorted, when a priority indicator of the respective evaluation indicator corresponding to the respective first candidate value can be calculated, calculation may be performed by using the respective evaluation indicator and evaluation indicators sorted before the respective evaluation indicator. In other words, for the selected evaluation indicator (i.e., at least one evaluation indicator of the plurality of evaluation indicators corresponding to the respective first candidate value) in Operation 20322, when the respective evaluation indicator corresponding to the respective first candidate value is the first evaluation indicator after sorting, the selected evaluation indicator (i.e., at least one evaluation indicator of the plurality of evaluation indicators corresponding to the respective first candidate value) can include the respective evaluation indicator corresponding to the respective first candidate value. When the respective evaluation indicator corresponding to the respective first candidate value is not the first evaluation indicator after sorting, the selected evaluation indicator (i.e., at least one evaluation indicator of the plurality of evaluation indicators corresponding to the respective first candidate value) can include the respective evaluation indicator corresponding to the respective first candidate value and evaluation indicators sorted before the respective evaluation indicator corresponding to the respective first candidate value.

Assuming that each first candidate value can correspond to M evaluation indicators, an example in which the respective first candidate value is an $i^{th}$ first candidate value and the respective evaluation indicator is an $m^{th}$ evaluation indicator is used, and at least one evaluation indicator in a plurality of evaluation indicators corresponding to the $i^{th}$ first candidate value can include the first to the $m^{th}$ evaluation indicators corresponding to the $i^{th}$ first candidate value.

Operation 20323: Determine a target indicator from the respective evaluation indicator corresponding to the respective first candidate value based on priority indicator of the respective evaluation indicator corresponding to the respective first candidate values.

In all embodiments of the present disclosure, the priority indicator of the respective evaluation indicator corresponding to the respective first candidate value may be determined in the manner in Operation 20322. Next, these priority indicators can be sorted, and the evaluation indicator corresponding to the respective priority indicators before a specified position after sorting can be determined as the target indicator. Alternatively, these priority indicators can be sorted, the sorted priority indicators can be segmented into a plurality of segments of indicators randomly or at equal intervals, and one segment of indicators can include at least one priority indicator after sorting. For the respective segment of indicators, the priority indicators included in the segment of indicators can be sampled, and an evaluation indicator corresponding to a sampled priority indicator can be determined as the target indicator. For example, the smallest priority indicator can be sampled from the priority indicators included in one segment of indicators, and an evaluation indicator corresponding to the smallest priority indicator can be determined as the target indicator. In this manner, the target indicators can be sampled from the segment of indicators. One or more target indicators can be used. In other words, at least one target indicator can be used. To be specific, the at least one target indicator can be determined from the respective evaluation indicator corresponding to the respective first candidate values based on the priority indicators of the respective evaluation indicators corresponding to the respective first candidate values.

Operation 20324: Determine a first candidate value corresponding to the target indicator as the first target candidate value.

In other words, for the respectve target indicator, a first candidate value corresponding to the respective target indicator can be determined as one first target candidate value. Because at least one target indicator can be used, at least one first target candidate value may be determined in this manner.

For example, the evaluation indicators corresponding to the first candidate values can be used as a training set, and the target indicator determined in Implementation B2 is an evaluation result corresponding to the most balanced parameter of a Pareto front of the training set. The Pareto front can be calculated in the training set, and a weighted Euclidean distance $d_i^{'}$ can be calculated on the Pareto front. The reference quality indicator can be determined through $d_i^{'}$, so that the accuracy of the target indicator can be improved, thereby improving the accuracy of the first target candidate value.

Next, a plurality of second reference values can be determined based on the plurality of first reference values and the first target candidate value. For example, one first reference value may be one second reference value, and one first target candidate value may be one second reference value. In other words, the first reference values and the first target candidate values may be used as the second reference values. Alternatively, the respective first reference value can be adjusted based on the first target candidate value to obtain an adjusted reference value corresponding to the respective first reference value, and the adjusted reference values corresponding to the respective first reference values can be used as the plurality of second reference values.

For example, at least one first target candidate value can be used, and a manner of adjusting the respective first reference value based on the first target candidate value to obtain an adjusted reference value corresponding to the respective first reference value may be: using an average value of the at least one first target candidate value as a first value, and adjusting the respective first reference value based on the first value to obtain the adjusted reference value corresponding to the respective first reference value. For example, an average value of the first value and the respective first reference value can be used as the adjusted reference value corresponding to the respective first reference value. In another example, a weighted averaging can be performed on the first value and the respective first reference value to obtain the adjusted reference value corresponding to the respective first reference value. In a process of performing the weighted averaging on the first value and the respective first reference value, a weight corresponding to the first value and a weight corresponding to the respective first reference value may be set empirically, or flexibly adjusted according to an application scenario. This is not limited in all embodiments of the present disclosure.

In a process of determining the first target candidate value, in consideration of different cases that the first candidate value can correspond to one or more evaluation indicators, in the different cases, the first target candidate value can be determined in different manners, so that the reliability of the manners of determining the first target candidate value is high, to further ensure the accuracy of the first target candidate value, thereby improving the accuracy of the eventually determined target value.

Operation 204: Perform a second quality detection on the original layout using the quality detection tool and based the second reference values to obtain a second quality indicator set comprising one or more second quality indicators. In all embodiments of the present disclosure, the second quality indicator set or one or more second quality indicators can correspond to the second reference values.

In all embodiments of the present disclosure, the quality detection tool can be determined by making the target parameter include the respective second reference value, an original layout can be inputted into the quality detection tool, and the quality detection tool performs a quality detection on the original layout to obtain a second quality indicator of the original layout corresponding to the second reference value. At least one second quality indicator can be used. To be specific, any second reference value can correspond to at least one second quality indicator, and a result of performing the quality detection on the original layout can include second quality indicators corresponding to the second reference values. The second quality indicator corresponding to the second reference value in this embodiment of this application is the second quality indicator of the original layout corresponding to the second reference value.

An implementation of Operation 204 is similar to the implementation of Operation 202, and refer to the description of Operation 202. Details are not described herein again.

Operation 205: In a case that the second quality indicator set meets the pre-defined quality condition, determine a target value of the target parameter of the quality detection tool using the second reference values. In all embodiments of the present disclosure, the quality detection tool with the target parameter of which the target value is determined can be considered as an updated quality detection tool which can be configured to determine a quality indicator of a to-be-detected layout.

That the second quality indicator set corresponding to the second reference values meets the pre-defined quality condition is that second quality indicators corresponding to all the second reference values meet the pre-defined quality condition. That a second quality indicator corresponding to the respective second reference value meets the pre-defined quality condition is not limited in all embodiments of the present disclosure. For example, it can be determined, based on a second quality indicator corresponding to the respective second reference value and a reference threshold, whether the second quality indicator corresponding to the respective second reference value meets the pre-defined quality condition. Alternatively, a quantity of iterations for determining the second quality indicators corresponding to the second reference values can be acquired, and it can be determined, based on the quantity of iterations and the quantity threshold, whether the second quality indicators corresponding to the second reference values meet the pre-defined quality condition.

Content of that the second quality indicator corresponding to the respective second reference value meets the pre-defined quality condition is similar to content of that the first quality indicator corresponding to the respective first reference value meets the pre-defined quality condition, and refer to the description of Operation 203. Details are not described herein again.

If the second quality indicators corresponding to the second reference values meet the pre-defined quality condition, the second reference values may be determined as the target values of the target parameter. Alternatively, for single-target minimization optimization, one second reference value can correspond to one second quality indicator, and according to the implementation principle of Implementation B1, a second reference value, which a second quality indicator corresponds to is greater than or less than a set threshold, may be selected from the plurality of second reference values, and the selected second reference value can be used as the target value. For example, one second reference value can correspond to one second quality indicator configured for representing an edge distance error of the original layout, and a second reference value with the smallest quality indicator can be selected from the plurality of second reference values as the target value. For the implementation principle of the foregoing content, refer to Implementation B1. Details are not described herein again.

For multiple-target minimization optimization, one second reference value can correspond to a plurality of second quality indicators. According to the implementation principle of Implementation B2, for the respective second quality indicator of the plurality of second quality indicators, a maximum value and a minimum value of the respective second quality indicator may be determined from the respective quality indicator corresponding to the respective second reference value. For the respective second quality indicator corresponding to the respective second reference value, a priority indicator of the respective quality indicator corresponding to the respective second reference value can be determined based on a second selected quality indicator and the maximum value and the minimum value of the second selected quality indicator, the second selected quality indicator being at least one of the plurality of second quality indicators corresponding to the respective second reference value, the second selected quality indicator including the respective quality indicator corresponding to the respective second reference value. A target quality indicator can be determined from the respective second quality indicators corresponding to the respective second reference values based on the priority indicator of the respective second quality indicator corresponding to the respective second reference value; and a second reference value corresponding to the target quality indicator can be determined as the target value. One or more target quality indicators can be used. In other words, at least one target quality indicator can be used. To be specific, the at least one target quality indicator can be determined from the second quality indicators corresponding to the second reference values based on the priority indicators of the respective second quality indicators corresponding to the respective second reference values. The target value determined in this manner is a value in a Pareto optimal solution set of the second reference values. For the implementation principle of the foregoing content, refer to Implementation B2. Details are not described herein again.

Alternatively, for multiple-target minimization optimization, one second reference value can correspond to a plurality of first quality indicators. Through the annotation of the original layout, an indicator interval corresponding to the quality indicators of the original layouts can be determined. For example, it can be determined through manual annotation that the mask complexity of the original layout ranges from 0.2 to 0.6, and an edge error ranges from 0.1 to 0.3. If the second quality indicators corresponding to one second reference value can be within a corresponding indicator interval, the second reference value can be determined as the target value. In this manner, at least one target value of the target parameter may be determined.

In a possible implementation, the method in all embodiments of the present disclosure can further include Operation 206 to Operation 208 (not shown in the figure). Operation 206 to Operation 208 can be performed after Operation 204.

Operation 206: In a case that the second quality indicator set corresponding to the second reference values do not meet the pre-defined quality condition, select a second target candidate value from a plurality of second candidate values based on the second quality indicator set corresponding to the second reference values, and determine a plurality of third reference values based on the plurality of second reference values and the second target candidate value, the plurality of second candidate values including first candidate values other than the first target candidate values in the plurality of first candidate values.

In all embodiments of the present disclosure, the first candidate values other than the first target candidate values of the plurality of first candidate values may be used as the second candidate values. If the second quality indicator set corresponding to the second reference values does not meet the pre-defined quality condition, according to an implementation principle similar to that of Operation 203, the second target candidate value can be determined from the second candidate values, and the third reference values can be determined based on the second reference values and the second target candidate value. For this part of content, refer to the description of Operation 203. Details are not described herein again.

One or more second target candidate values can be used. In other words, at least one second target candidate value can be used. To be specific, at least one second target candidate value can be determined from the plurality of second candidate values based on the second quality indicator set corresponding to the second reference values, the plurality of third reference values can be determined based on the plurality of second reference values and the at least one second target candidate value, the plurality of second candidate values including first candidate values other than the at least one first target candidate value of the plurality of first candidate values.

In some embodiments, the "selecting a second target candidate value from a plurality of second candidate values based on the second quality indicator set corresponding to the second reference values, and determining a plurality of third reference values based on the plurality of second reference values and the second target candidate value" in Operation 206 can include Operation 2061 to Operation 2065 (not shown in the figure).

Operation 2061: Adjust the pre-set value range of the target parameter to obtain a second value range of the target parameter.

In all embodiments of the present disclosure, it may be flexibly selected according to an actual case to expand the pre-set value range, to reduce the pre-set value range, or not to adjust the pre-set value range. When the pre-set value range is expanded or reduced, the expanded or reduced pre-set value range is a second value range.

In some embodiments, Operation 2061 can include: determining a first quality indicator not greater than a first indicator threshold from the first quality indicator set corresponding to the first reference values; determining a second quality indicator not greater than a second indicator threshold from the second quality indicator set corresponding to the second reference values; in a case that the determined first quality indicator is less than the determined second quality indicator, reducing the pre-set value range to obtain the second value range; and in a case that the determined first quality indicator is greater than the determined second quality indicator, expanding the pre-set value range to obtain the second value range.

The first indicator threshold and the second indicator threshold may be not limited in all embodiments of the present disclosure. For example, the first indicator threshold and the second indicator threshold can be values set empirically, or the first indicator threshold is the smallest first quality indicator of the first quality indicator set corresponding to the first reference values, and the second indicator threshold is the smallest second quality indicator of the second quality indicator set corresponding to the second reference values.

For the respective first quality indicator corresponding to the respective first reference value, if the respective first quality indicator is less than or equal to the first indicator threshold, the respective first quality indicator can be acquired as the determined first quality indicator. In this manner, the at least one first quality indicator can be acquired from the first quality indicator set corresponding to the first reference values. In the same manner, at least one second quality indicator can be acquired from the second quality indicator set corresponding to the second reference values.

If the first indicator threshold is the smallest first quality indicator of the first quality indicator set corresponding to the first reference values, the determined first quality indicator may be the smallest first quality indicator of the first quality indicator set corresponding to the first reference values. Similarly, the determined second quality indicator may be the smallest second quality indicator of the second quality indicator set corresponding to the second reference values.

Next, it can be determined, based on the determined first quality indicators and the determined second quality indicators, whether to reduce or expand the pre-set value range. In some embodiments, if the determined first quality indicators are less than the determined second quality indicators, the pre-set value range can be reduced, and if the determined first quality indicators are greater than the determined second quality indicators, the pre-set value range can be expanded.

For example, one or more determined first quality indicators may be used, and one or more determined second quality indicators may also be used. That the determined first quality indicator is less than the determined second quality indicator may be that an average value of the determined first quality indicators is less than an average value of the determined second quality indicators, and that the determined first quality indicator is greater than the determined second quality indicator may be that the average value of the determined first quality indicators is greater than the average value of the determined second quality indicators.

For example, for single-target optimization or multiple-target optimization, the smallest first quality indicator may be determined from the first quality indicator set corresponding to the first reference values to obtain the determined first quality indicator. The smallest second quality indicator can be determined from the second quality indicator set corresponding to the second reference values to obtain the determined second quality indicator. If the determined first quality indicator is less than the determined second quality indicator, the pre-set value range can be halved with the first reference value corresponding to the determined first quality indicator as the center or with the second reference value corresponding to the determined second quality indicator as the center. If the determined first quality indicator is greater than the determined second quality indicator, the pre-set value range can be doubled with the first reference value corresponding to the determined first quality indicator as the center or with the second reference value corresponding to the determined second quality indicator as the center.

In some embodiments, for multiple-target optimization, it may be determined, in the following manner, whether to reduce or expand the pre-set value range. In Operation S213, the reference quality indicator can be determined from the first quality indicator set corresponding to the first reference values, and the reference quality indicator may be determined as the determined first quality indicator. In addition, the determined second quality indicator can be acquired from the second quality indicator set corresponding to the second reference values according to the implementation principle in Operation S213. If the determined first quality indicator is less than the determined second quality indicator, the pre-set value range can be halved with the first reference value corresponding to the determined first quality indicator as the center or with the second reference value corresponding to the determined second quality indicator as the center. If the determined first quality indicator is greater than the determined second quality indicator, the pre-set value range can be doubled with the first reference value corresponding to the determined first quality indicator as the center or with the second reference value corresponding to the determined second quality indicator as the center.

In all embodiments of the present disclosure, the target value can be determined in an iterative manner. Therefore, it may be determined, for every specific quantity of iterations, whether to reduce or expand a value range. In other words, in N (N is a positive integer, for example, N is 3) iterations, a previous iteration can correspond to the determined first quality indicator in all embodiments of the present disclosure, and a next iteration can correspond to the determined second quality indicator in all embodiments of the present disclosure. If the determined first quality indicator is less than the determined second quality indicator in every two adjacent iterations, the value range can be reduced, and if the determined first quality indicator is greater than the determined second quality indicator in two adjacent iterations, the value range can be expanded.

A length of the reduced value range is not less than a first length, and a length of an expanded value range is not greater than a second length. To be specific, the value ranges before and after reduction and expansion need to be constrained to be appropriate, to avoid extreme cases. In other words, a length of the second value range is not less than the first length, and the length of the second value range is not greater than the second length. The first length is a minimum length of an appropriate value range, the second length is a maximum length of the appropriate value range, and the first length and the second length may be set empirically, or flexibly adjusted according to an application scenario. This is not limited in all embodiments of the present disclosure.

In some embodiments, the reducing the value range is also referred to as reducing a mesh, and the expanding the value range is also referred to as expanding the mesh. A value space of the target parameter can be optimized by reducing and expanding the mesh. When the second candidate values and the third reference values can be determined based on the optimized value space subsequently (refer to Operations 2062 to 2065), the accuracy of the second candidate values and the third reference values can be improved, and the efficiency of seeking a Pareto optimal solution can be improved, to be specific, the efficiency of determining the target value can be improved. In addition, the value can be kept from being increased blindly, to take both a calculation amount and calculation efficiency into consideration, thereby determining the target value with a small calculation amount and high calculation efficiency.

Operation 2062: Divide the second value range into a plurality of second value intervals.

In all embodiments of the present disclosure, an implementation principle of Operation 2062 is similar to the implementation principle of "dividing the first value range into a plurality of first value intervals", and refer to the description of Operation 201. Details are not described herein again.

Operation 2063: Perform a sampling in the second value intervals to obtain a plurality of first supplementary values and a plurality of second supplementary values.

In all embodiments of the present disclosure, a manner of determining the first supplementary values is similar to the manner of determining the first candidate value in Operation 201, and a manner of determining the second supplementary values is similar to the manner of determining the first reference values in Operation 201. Therefore, an implementation principle of Operation 2063 is similar to the implementation principle of "performing a sampling in the first value intervals to obtain the plurality of first reference values and the plurality of first candidate values", refer to the description of 201. Details can be not described herein again.

Operation 2064: Determine the plurality of first supplementary values and first candidate values other than the first target candidate values among the plurality of first candidate values as the plurality of second candidate values, and determine a second target candidate value from the plurality of second candidate values based on the second quality indicator set corresponding to the second reference values.

In all embodiments of the present disclosure, the plurality of second candidate values can include the plurality of first supplementary values and the first candidate values other than the first target candidate values among the plurality of first candidate values. The second target candidate value may be determined from the second candidate values according to the implementation principle similar to that of Operation 203. At least one first target candidate value and at least one second target candidate value can be used. To be specific, the plurality of first supplementary values and the first candidate values other than the at least one first target candidate values of the plurality of first candidate values can be determined as the plurality of second candidate values, and the at least one second target candidate value can be determined from the plurality of second candidate values based on the second quality indicator set corresponding to the second reference values.

Operation 2065: Determine the plurality of second supplementary values, the plurality of second reference values, and the second target candidate value as the plurality of third reference values. To be specific, the third reference values include the second supplementary values, the second reference values, and the second target candidate value.

At least one second target candidate value can be used. To be specific, the plurality of second supplementary values, the plurality of second reference values,

and the second target candidate values can be determined as the plurality of third reference values.

Operation 207: Perform a third quality detection on the original layout according to the plurality of third reference values by using the quality detection tool to obtain a third quality indicator set comprising one or more third quality indicators corresponding to the third reference values.

In all embodiments of the present disclosure, the quality detection tool can be determined with the target parameter including the respective third reference value, an original layout can be inputted into the quality detection tool, and the quality detection tool can perform a third quality detection on the original layout to obtain a third quality indicator set of the original layout corresponding to the third reference value. At least one third quality indicator can be used. To be specific, the respective third reference value can correspond to at least one third quality indicator, and a result of performing the third quality detection on the original layout can include third quality indicators corresponding to the third reference values. The third quality indicator corresponding to the third reference value in this embodiment of this application is the third quality indicator of the original layout corresponding to the third reference value.

An implementation of Operation 207 is similar to the implementation of Operation 202, and refer to the description of Operation 202. Details are not described herein again.

Operation 208: In a case that the third quality indicator set meets the pre-defined quality condition, determine the target value of the target parameter of the quality detection tool using the third reference values. In all embodiments of the present disclosure, the third quality indicator set can correspond to the third reference values.

That a third quality indicator corresponding to the respective third reference value meets the pre-defined quality condition is not limited in all embodiments of the present disclosure. For example, it may be determined, based on a third quality indicator corresponding to the respective third reference value and a reference threshold, whether the third quality indicator corresponding to the respective third reference value meets the pre-defined quality condition. Alternatively, a quantity of iterations for determining the third quality indicators corresponding to the third reference values can be acquired, and it can be determined, based on the quantity of iterations and the quantity threshold, whether the third quality indicators corresponding to the third reference values meet the pre-defined quality condition.

Content of that the third quality indicator corresponding to the respective third reference value meets the pre-defined quality condition is similar to content of that the first quality indicator corresponding to the respective first reference value meets the pre-defined quality condition, and refer to the description of Operation 203. Details are not described herein again.

If the third quality indicator set corresponding to the third reference values meets the pre-defined quality condition, the target value may be determined from the plurality of third reference values. For a manner of determining the target value from the plurality of third reference values, refer to the description of Operation 205, and the implementation principles of the two are similar. Details are not described herein again.

In all embodiments of the present disclosure, the determining the target value of the target parameter can be equivalent to completing the adjustment of the parameter of the quality detection tool. A quality detection tool with the adjusted parameter can be used as a quality detection tool with a value of the target parameter being the target value, and the accuracy of the quality detection tool is high. Subsequently, any chip layout, any mask layout or any wafer layout may be used as the to-be-detected layout. A quality detection can be performed on the to-be-detected layout according to the target parameter by using the quality detection tool with the adjusted parameter to obtain the quality indicator of the to-be-detected layout.

In some embodiments, a photolithography device in an actual scenario can be simulated by using the quality detection tool with the adjusted parameter, photolithography can be performed on the to-be-detected layout to obtain a photolithography layout, and a pattern analysis can be performed on the photolithography layout to obtain the quality indicator of the to-be-detected layout. For example, when the to-be-detected layout is a chip layout, the photolithography layout may be at least one of a mask layout and a wafer layout. When the to-be-detected layout is a mask layout, the photolithography layout may be a wafer layout. When the to-be-detected layout is a chip layout, the photolithography layout may be a wafer layout. In this case, the quality indicator of the to-be-detected layout may be determined based on the to-be-detected layout and the photolithography layout by using the quality detection tool.

Alternatively, a pattern of the to-be-detected layout may be analyzed according to the target value by using the quality detection tool to obtain the quality indicator of the to-be-detected layout.

A manner of determining the quality indicator of the to-be-detected layout is similar to the manner of determining the quality indicator of the original layout, and refer to the description of Operation 202. Details are not described herein again.

Next, it can be determined, based on a relationship between the quality indicator of the to-be-detected layout and a target threshold, whether the to-be-detected layout is a base layout. In some embodiments, if the quality indicator is negatively correlated with the quality of the to-be-detected layout, when the quality indicator of the to-be-detected layout is not greater than the target threshold, it can be determined that the to-be-detected layout is the base layout, and when the quality indicator of the to-be-detected layout is greater than the target threshold, it can be determined that the to-be-detected layout is not the base layout. Similarly, if the quality indicator is positively correlated with the quality of the to-be-detected layout, when the quality indicator of the to-be-detected layout is not less than the target threshold, it can be determined that the to-be-detected layout is the base layout, and when the quality indicator of the to-be-detected layout is less than the target threshold, it can be determined that the to-be-detected layout is not the base layout.

In a case that the determined to-be-detected layout is a base layout: If the base layout is a chip layout, the photolithography device in the actual scenario may be invoked first, and photolithography can be performed on a mask based on the chip layout to obtain the mask after photolithography. Next, the photolithography device in the actual scenario can be invoked again to perform photolithography on a wafer based on the mask after photolithography to obtain the wafer after photolithography. If the base layout is a mask layout, the photolithography device in the actual scenario may be invoked, and photolithography can be performed on a wafer based on a mask after photolithography corresponding to the mask layout to obtain the wafer after photolithography. Certainly, during application, the base layout may be a layout on the wafer after photolithography, i.e., a wafer layout. In some embodiments, the wafer after photolithography is also referred to as an integrated circuit wafer, and is a product in a chip manufacturing process.

In a case that the base layout is a chip layout or a mask layout, a base layout of high quality can be selected, so that integrated circuit wafers of high quality can be manufactured based on the base layout, to reduce a defective rate of integrated circuit wafers, thereby reducing the production costs of integrated circuit wafers. In a case that the base layout is a wafer layout, a base layout of high quality can be selected, so that integrated circuit wafers of high quality can be selected, to reduce a defective rate of integrated circuit wafers.

Information (including, but not limited to, device information of a user, and personal information of a user), data (including, but not limited to, data for analysis, stored data, and displayed data), and signals in all embodiments of the present disclosure can be all authorized by a user or fully authorized by all parties, and the collection, use, and processing of relevant data need to comply with the relevant laws, regulations, and standards of the relevant regions. For example, the original layout, the first value range, and the like in this application can be all obtained with full authorization.

In the foregoing method, a target parameter of a quality detection tool can include first reference values, and a first quality detection can be performed on an original layout by using the quality detection tool to obtain one or more first quality indicators corresponding to the first reference values. If the one or more first quality indicators corresponding to the first reference values do not meet a pre-defined quality condition, a first target candidate value can be determined from a plurality of first candidate values of the target parameter based on the one or more first quality indicators corresponding to the first reference values, and a plurality of second reference values of the target parameter can be determined based on the plurality of first reference values and the first target candidate value. The second reference values can be determined, so that the accuracy of a value space of the target parameter can be improved. A second quality detection can be performed on the original layout by using the quality detection tool to obtain one or more second quality indicators corresponding to the second reference values. The accuracy of the value space of the target parameter can be improved, to improve the accuracy of the quality detection tool, so that the accuracy of quality indicators can be improved, and in a case that the one or more second quality indicators corresponding to the second reference values meet the pre-defined quality condition, a target value of the target parameter can be accurately determined based on the second reference values, thereby ensuring the accuracy of the quality detection tool, helping to improve the accuracy of quality indicators of to-be-detected layouts determined by the quality detection tool, and more accurately selecting a layout with better quality from the to-be-detected layouts.

In addition, a sampling can be performed in the plurality of first value intervals to obtain the first reference values and the first candidate values, which helps to improve the distribution uniformity of the first reference values and the first candidate values, thereby ensuring the comprehensiveness of the first reference values and the first candidate values. The first reference values can be determined in a clustering manner, to improve the accuracy of the first reference values, so that the efficiency of determining a target value can be increased.

The first quality indicators of the original layouts corresponding to the first reference values can be calculated through errors between the original layout and the predicted layouts corresponding to the first reference values, so that the first quality indicators of the original layouts corresponding to the first reference values can reflect the accuracy of the quality detection tool. In this way, a value of the parameter of the quality detection tool can be adjusted to be more accurate based on the first quality indicators of the original layouts corresponding to the first reference values, thereby ensuring the accuracy of the quality detection tool.

The evaluation indicator of the first candidate value can be determined by considering the statistical distribution and the statistical information, thereby ensuring the accuracy of the evaluation indicator of the first candidate value. In addition, in a process of determining the evaluation indicator of the first candidate value, in consideration of different cases that the first reference value can correspond to one or more first quality indicators, in the different cases, the evaluation indicator of the first candidate value can be determined in different manners, so that the reliability of the manners of determining the evaluation indicator of the first candidate value is high, to further ensure the accuracy of the evaluation indicator of the first candidate value, thereby improving the accuracy of the eventually determined target value.

In a process of determining the first target candidate value, in consideration of different cases that the first candidate value can correspond to one or more evaluation indicators, in the different cases, the first target candidate value can be determined in different manners, so that the reliability of the manners of determining the first target candidate value is high, to further ensure the accuracy of the first target candidate value, thereby improving the accuracy of the eventually determined target value.

A value space of the target parameter can be optimized by reducing and expanding the value range of the target parameter. When the second candidate values and the third reference values can be determined based on the optimized value space, the accuracy of the second candidate values and the third reference values can be improved, and the efficiency of determining the target value can be improved. In addition, the value can be kept from being increased blindly, to take both a calculation amount and calculation efficiency into consideration, thereby determining the target value with a small calculation amount and high calculation efficiency.

The method provided in all embodiments of the present disclosure is described above from the perspective of method operations, and is described below with reference to a scenario. Two scenarios can be provided in all embodiments of the present disclosure. One is a scenario of determining a parameter of a quality detection tool for a single quality indicator, and the other is a scenario of determining a parameter of a quality detection tool for two quality indicators. The two scenarios can be separately described below.

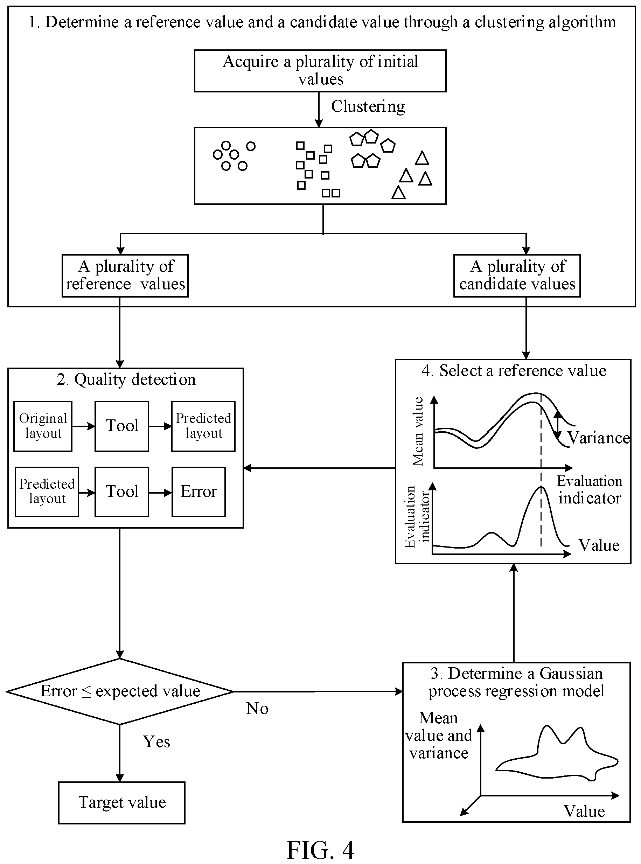

First, the scenario of determining a parameter of a quality detection tool for a single quality indicator is described. For example, the quality indicator can be an error. FIG. 4 is a schematic flowchart of determining a parameter of a quality detection tool for a single quality indicator according to an embodiment of the present disclosure. The procedure can include Operation 1 to Operation 4 below.

Operation 1: Determine a reference value and a candidate value through a clustering algorithm.

In all embodiments of the present disclosure, a plurality of initial values may be acquired, and the plurality of initial values can be clustered to obtain clusters. For the respective cluster, an initial value having the smallest distance from a cluster center of the respective cluster can be selected from the respective cluster, the selected initial value can be used as the reference value, and an unselected initial value can be used as the candidate value. In this manner, the plurality of initial values can be classified into a plurality of reference values and a plurality of candidate values. For an implementation of Operation 1, refer to the description of Operation 201. Details are not described herein again.

Operation 2: Perform a quality detection on an original layout by using a quality detection tool with a target parameter of the quality detection tool including a plurality of reference values to obtain errors of original layouts corresponding to the reference values.

In all embodiments of the present disclosure, the quality detection tool can be determined by making the target parameter of the quality detection tool as the respective reference value. The original layout can be inputted into the quality detection tool, and a predicted layout corresponding to the reference value is outputted through the quality detection tool. Next, the predicted layout corresponding to the reference value can be inputted into the quality detection tool, and the quality detection tool determines an error of the original layout corresponding to the reference value. In this manner, the errors corresponding to the reference values may be determined. For an implementation of Operation 2, refer to the description of Operation 202. Details are not described herein again.

If the errors corresponding to the reference values are less than or equal to an expected value, a target value can be determined based on the reference values. For a manner of determining the target value, refer to the description of Operation 205. Details are not described herein again. If the errors corresponding to the reference values are greater than the expected value, Operation 3 is performed.

Operation 3: Determine a Gaussian process regression model based on the errors corresponding to the reference values.

In all embodiments of the present disclosure, the errors corresponding to the reference values meet a Gaussian distribution. In this case, the Gaussian process regression model can be configured to describe a mapping relationship between a reference value and a mean value of a Gaussian distribution and a variance of the Gaussian distribution. For an implementation principle of Operation 3, refer to the description of Operation S1. Details are not described herein again.

Operation 4: Determine, based on the Gaussian process regression model and a plurality of candidate values, evaluation indicators of the candidate values, and select the reference value from the plurality of candidate values based on the evaluation indicators of the candidate values.

In all embodiments of the present disclosure, the Gaussian process regression model can be configured to describe a mapping relationship between a reference value and a mean value of a Gaussian distribution and a variance of the Gaussian distribution. Therefore, any candidate value can be mapped into a corresponding mean value and variance by using the Gaussian process regression model. Next, based on a mean value and a variance corresponding to any candidate value, an evaluation indicator of the candidate value is determined, and it can be determined, based on the evaluation indicator of the candidate value, whether the candidate value is a reference value. In this manner, the reference value can be selected from the plurality of candidate values. For an implementation principle of Operation 4, refer to the description of Operation S2, Implementation A1, and Implementation B1. Details are not described herein again.

Next, the reference value selected in Operation 4 and the reference value determined in Operation 1 can be considered as reference values in one set, and Operation 2 can be performed again based on these reference values to obtain the errors corresponding to the reference values. If the errors corresponding to the reference values can be less than or equal to the expected value, the target value can be determined based on the reference values. If the errors corresponding to the reference values can be greater than the expected value, Operation 3, Operation 4, and Operation 2 can be performed repeatedly, until the target value is determined.

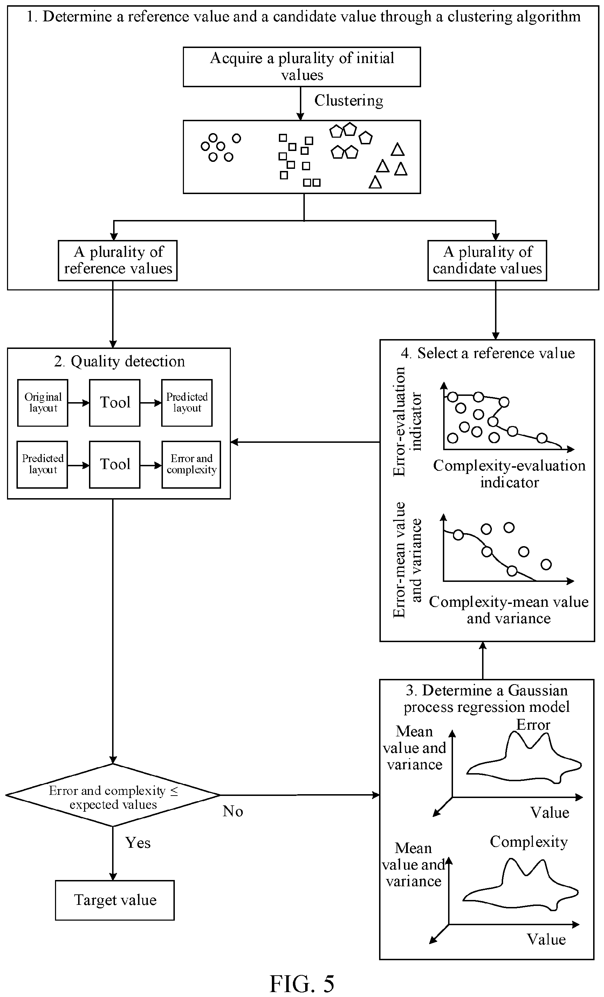

Next, the scenario of determining a parameter of a quality detection tool for a plurality of quality indicators is described. For example, the plurality of quality indicators can be two quality indicators, and the two quality indicators can be an error and a complexity. FIG. 5 is a schematic flowchart of determining a parameter of a quality detection tool for two quality indicators according to an embodiment of this application. The procedure can include Operation 1 to Operation 4 below.

Operation 1: Determine a reference value and a candidate value through a clustering algorithm.

In all embodiments of the present disclosure, a plurality of initial values may be acquired, and the plurality of initial values can be clustered to obtain clusters. For the respective cluster, an initial value having the smallest distance from a cluster center of the respective cluster can be selected from the respective cluster, the selected initial value can be used as the reference value, and an unselected initial value can be used as the candidate value. In this manner, the plurality of initial values can be classified into a plurality of reference values and a plurality of candidate values. For an implementation of Operation 1, refer to the description of Operation 201. Details are not described herein again.

Operation 2: Perform a quality detection on an original layout by using a quality detection tool with a target parameter of the quality detection tool including a plurality of reference values to obtain errors and complexities of original layouts corresponding to the reference values.

In all embodiments of the present disclosure, the quality detection tool can be determined by making the target parameter of the quality detection tool as the respective reference value. The original layout can be inputted into the quality detection tool, and a predicted layout corresponding to the reference value can be outputted through the quality detection tool. Next, the predicted layout corresponding to the reference value can be inputted into the quality detection tool. In one aspect, the quality detection tool can determine an error of the original layout corresponding to the reference value. In another aspect, the quality detection tool can determine a complexity of the original layout corresponding to the reference value. In this manner, the errors and complexities corresponding to the reference values may be determined. For an implementation of Operation 2, refer to the description of Operation 202. Details are not described herein again.

If the errors corresponding to the reference values can be less than or equal to an expected value corresponding to the errors and the complexities corresponding to the reference values can be less than or equal to an expected value corresponding to the complexities, a target value can be determined based on the reference values. For a manner of determining the target value, refer to the description of Operation 205. Details are not described herein again. If an error corresponding to a reference value can be greater than an expected value corresponding to the error, and/or a complexity corresponding to a reference value can be greater than an expected value corresponding to the complexity, Operation 3 can be performed.

Operation 3: Determine, based on the errors corresponding to the reference values, a Gaussian process regression model corresponding to the errors, and determine, based on the complexities corresponding to the reference values, a Gaussian process regression model corresponding to the complexities.

In all embodiments of the present disclosure, the errors corresponding to the reference values meet a Gaussian distribution. In this case, the Gaussian process regression model corresponding to the errors can be configured to describe a mapping relationship between a reference value and a mean value of a Gaussian distribution that the errors meet and a variance of the Gaussian distribution. Similarly, the complexities corresponding to the reference values also meet the Gaussian distribution. In this case, the Gaussian process regression model corresponding to the complexities can be configured to describe a mapping relationship between a reference value and a mean value of a Gaussian distribution that the complexities meet and a variance of the Gaussian distribution. For an implementation principle of Operation 3, refer to the description of Operation S1. Details are not described herein again.

Operation 4: Determine, based on the Gaussian process regression model and a plurality of candidate values, evaluation indicators of the candidate values, and select the reference value from the plurality of candidate values based on the evaluation indicators of the candidate values.

In all embodiments of the present disclosure, the Gaussian process regression model corresponding to the errors can be configured to describe a mapping relationship between a reference value and a mean value of a Gaussian distribution that the errors meet and a variance of the Gaussian distribution. Therefore, any candidate value can be mapped into a mean value and a variance that correspond to an error by using the Gaussian process regression model corresponding to the error. Based on the similar principle, any candidate value can be mapped into a mean value and a variance that correspond to a complexity by using the Gaussian process regression model corresponding to the complexity.

Next, based on a mean value and a variance that correspond to an error of any candidate value and a mean value and a variance that correspond to a complexity of the candidate value, an evaluation indicator corresponding to the error of the candidate value and an evaluation indicator corresponding to the complexity of the candidate value can be determined, to determine, based on the evaluation indicator corresponding to the error of the candidate value and the evaluation indicator corresponding to the complexity of the candidate value, whether the candidate value is a reference value. In this manner, the reference value can be selected from the plurality of candidate values. For an implementation principle of Operation 4, refer to the description of Operation S2, Implementation A2, and Implementation B2. Details are not described herein again.

Next, the reference value selected in Operation 4 and the reference value determined in Operation 1 can be considered as reference values in one set, and Operation 2 can be performed again based on these reference values to obtain the errors and the complexities corresponding to the reference values. If the errors corresponding to the reference values can be less than or equal to an expected value corresponding to the errors and the complexities corresponding to the reference values can be less than or equal to an expected value corresponding to the complexities, a target value can be determined based on the reference values; or otherwise, Operation 3, Operation 4, and Operation 2 can be performed repeatedly, until the target value is determined.

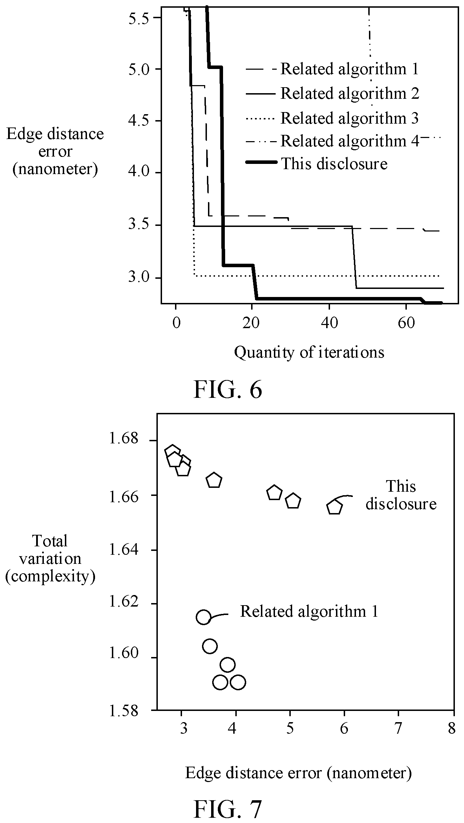

In all embodiments of the present disclosure, according to the flowchart in FIG. 4, a parameter of the quality detection tool can be determined for an edge distance error. Statistics of a relationship between a quantity of iterations and an edge distance error can be collected to obtain a corresponding relationship line in FIG. 6. In addition, the parameter of the quality detection tool can be further determined for the edge distance error by using four correlation algorithms. Statistics of relationships between a quantity of iterations and an edge distance error corresponding to various correlation algorithms can be collected to obtain relationship lines corresponding to Correlation algorithms 1 to 4 in FIG. 6. Correlation algorithm 1 can be a random algorithm, Correlation algorithm 2 can be a particle swarm optimization (PSO) algorithm, Correlation algorithm 3 can be a social learning particle swarm optimization (SLPSO) algorithm, and Correlation algorithm 4 can be a random walking (RW) algorithm.

As can be learned from FIG. 6, after 20 iterations, the relationship line corresponding to this application has the smallest edge distance error, and converges faster compared with the correlation algorithms. As can be learned, the method in all embodiments of the present disclosure can determine a value of a target parameter of high accuracy with a small calculation amount, thereby improving the accuracy of the quality detection tool.

In addition, according to the flowchart in FIG. 5, a parameter of the quality detection tool may be determined for an edge distance error and a complexity. A data distribution corresponding to this application in FIG. 7 can be obtained by collecting statistics of a relationship between an edge distance error and a related complexity total variation. In addition, the parameter of the quality detection tool can be further determined for the edge distance error and the complexity by using Correlation algorithm 1. A data distribution corresponding to Correlation algorithm 1 in FIG. 7 can be obtained by collecting statistics of a relationship between an edge distance error and a related complexity total variation.

As can be learned from FIG. 7, in multiple-target optimization, compared with the correlation algorithms, the method in all embodiments of the present disclosure can reach a smaller edge distance error. Each piece of data in FIG. 7 is a Pareto optimal solution. The data distribution of this application can correspond to 8 Pareto optimal solutions, and the data distribution of Correlation algorithm 1 can correspond to 5 Pareto optimal solutions, indicating that the method in all embodiments of the present disclosure can have more Pareto optimal solutions, making the accuracy of the quality detection tool higher.

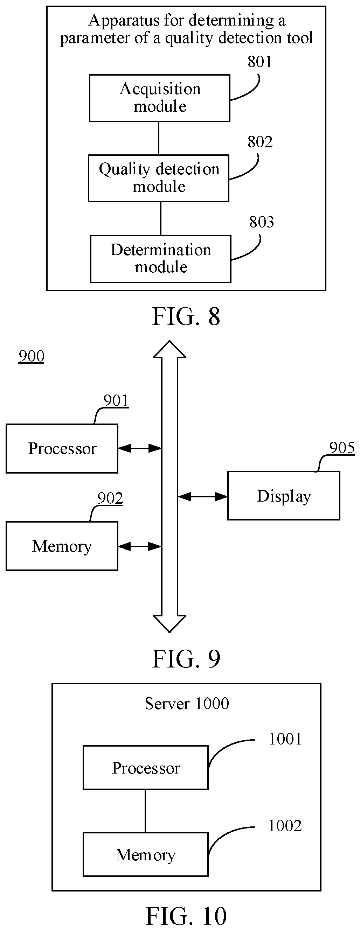

FIG. 8 is a schematic structural diagram of an apparatus for determining a parameter of a quality detection tool according to an embodiment of this application. As shown in FIG. 8, the apparatus includes:

an acquisition module 801, configured to determine, for a target parameter of a quality detection tool, a plurality of first reference values within a pre-set value range and determine a plurality of first candidate values from the pre-set value range excluding the determined first reference values;

a quality detection module 802, configured to perform a first quality detection on an original layout using the quality detection tool and based on the plurality of first reference values to obtain a first quality indicator set comprising one or more first quality indicators; and

a determination module 803, configured to: in a case that the first quality indicator set does not meet a pre-defined quality condition, select a first target candidate value from the first candidate values based on the first quality indicator set, and determine, for the target parameter, a plurality of second reference values based on the first reference values and the first target candidate value;

the quality detection module 802 being further configured to perform a second quality detection on the original layout using the quality detection tool and based on the second reference values to obtain a second quality indicator set comprising one or more second quality indicators;

the determination module 803 being further configured to in a case that the second quality indicator set meets the pre-defined quality condition, determine a target value of the target parameter of the quality detection tool using the second reference values. In all embodiments of the present disclosure, the quality detection tool with the target parameter of which the target value is determined can be considered as an updated quality detection tool which can be configured to determine a quality indicator of a to-be-detected layout.

In a possible implementation, the acquisition module 801 can be configured to: acquire a first value range of the target parameter as the pre-set value range; divide the first value range into a plurality of first value intervals; and perform a sampling in the first value intervals to obtain the plurality of first reference values and the plurality of first candidate values.

In a possible implementation, the acquisition module 801 can be configured to: perform the sampling in the first value intervals to obtain a plurality of first initial values of the target parameter; cluster the plurality of first initial values to obtain a plurality of target clusters, each of the target clusters including at least one first initial value of the plurality of first initial values; and for the respective target cluster in the plurality of target clusters, select at least one first initial value from the respective target cluster as the first reference values, and determine the first initial values other than the selected first initial values in the respective target cluster as the first candidate values.

In a possible implementation, the quality detection module 802 can be configured to: process the original layout according to the plurality of first reference values by using the quality detection tool to obtain predicted layouts corresponding to the first reference values, and determine the first quality indicator set corresponding to the first reference values based on the predicted layouts corresponding to the first reference values.

In a possible implementation, the quality detection module 802 can be configured to: for the respective first reference value of the first reference values, determine an error between the original layout and a predicted layout corresponding to the respective first reference value; and determine at least one first quality indicator corresponding to the respective first reference value based on the error between the original layout and the predicted layout corresponding to the respective first reference value.

In a possible implementation, the determination module 803 can be configured to: determine at least one evaluation indicator for the respective first candidate values based on at least one first quality indicator corresponding to the respective first reference values, the at least one evaluation indicator for the respective first candidate value being configured for describing a possibility that a quality indicator meets the pre-defined quality condition when a quality detection is performed on the original layout by using the quality detection tool in a case that the target parameter includes the respective first candidate value; and determine the first target candidate value from the plurality of first candidate values based on the at least one evaluation indicators for the respective first candidate values.

In a possible implementation, the determination module 803 can be configured to: determine a first mapping relationship based on the respective first reference values and the at least one first quality indicators corresponding to the respective first reference values, the first mapping relationship being configured for describing a mapping relationship between the respective first reference values and statistical information of a statistical distribution in a case that the at least one first quality indicator corresponding to the respective first reference values meets the statistical distribution; and for the respective first candidate value of the first candidate values, determine statistical information corresponding to the respective first candidate value based on the respective first candidate value and the first mapping relationship, and determine the at least one evaluation indicator for the respective first candidate value based on the statistical information corresponding to the respective first candidate value.

In a possible implementation, the statistical information corresponding to the respective first candidate value can include a mean value and a variance; and the determination module 803 can be configured to: determine a reference quality indicator from the at least one first quality indicator corresponding to the respective first reference values; determine a normal distribution function corresponding to the respective first candidate value based on the reference quality indicator and the mean value and the variance corresponding to the respective first candidate value; and determine the at least one evaluation indicator for the respective first candidate value based on the variance corresponding to the respective first candidate value, the normal distribution function corresponding to the respective first candidate value, and a cumulative density function and a probability density function of the normal distribution function corresponding to the respective first candidate value.

In a possible implementation, the respective first reference value can correspond to one first quality indicator; and the determination module 803 can be configured to: determine the smallest first quality indicator from the at least one first quality indicator corresponding to the respective first reference value, and determine the smallest first quality indicator as the reference quality indicator.

In a possible implementation, the respective first reference value can correspond to a plurality of first quality indicators; and the determination module 803 can be configured to: for the respective first quality indicator of the plurality of first quality indicators, determine a maximum value and a minimum value of the respective first quality indicator from the respective quality indicators corresponding to the respective first reference values; for the respective first quality indicator corresponding to the respective first reference value, determine a priority indicator of the respective first quality indicator corresponding to the respective first reference value based on a first selected quality indicator, a weight of the first selected quality indicator, and the maximum value and the minimum value of the first selected quality indicator, the first selected quality indicator being at least one of the plurality of first quality indicators corresponding to the respective first reference value, the first selected quality indicator including the respective first quality indicator corresponding to the respective first reference value; and determine the reference quality indicator from the respective first quality indicators corresponding to the respective first reference value based on the priority indicator of the respective first quality indicators corresponding to the respective first reference values.

In a possible implementation, the determination module 803 can be configured to: determine a difference between the reference quality indicator and the mean value corresponding to the respective first candidate value; and use a quotient of the difference by the variance corresponding to the respective first candidate value as the normal distribution function corresponding to the respective first candidate value.

In a possible implementation, the determination module 803 can be configured to: multiply the normal distribution function corresponding to the respective first candidate value by the cumulative density function of the normal distribution function corresponding to the respective first candidate value to obtain a multiplication result; add the multiplication result to the probability density function of the normal distribution function corresponding to the respective first candidate value to obtain an addition result; and multiply the addition result by the variance corresponding to the respective first candidate value to obtain the at least one evaluation indicator for the respective first candidate value.

In a possible implementation, the respective first candidate value can correspond to one evaluation indicator, and the determination module 803 can be configured to select a first candidate value, which the evaluation indicator corresponding to is not less than a set indicator threshold, from the plurality of first candidate values based on the evaluation indicators corresponding to the respective first candidate values as the first target candidate value.

In a possible implementation, the respective first candidate value can correspond to a plurality of evaluation indicators; and the determination module 803 can be configured to: for the respective evaluation indicator of the plurality of evaluation indicators, determine a maximum value and a minimum value of the respective evaluation indicator from the respective evaluation indicators corresponding to the respective first candidate values; for the respective evaluation indicator corresponding to the respective first candidate value, determine a priority indicator of the respective evaluation indicator corresponding to the respective first candidate value based on a selected evaluation indicator and the maximum value and the minimum value of the selected evaluation indicator, the selected evaluation indicator being at least one of the plurality of evaluation indicators corresponding to the respective first candidate value, the selected evaluation indicator including the respective evaluation indicator corresponding to the respective first candidate value; determine a target indicator from the respective evaluation indicators corresponding to the respective first candidate values based on the priority indicators of the respective evaluation indicators corresponding to the respective first candidate values; and determine a first candidate value corresponding to the target indicator as the first target candidate value.

In a possible implementation, the determination module 803 can be further configured to: in a case that the second quality indicator set corresponding to the second reference values does not meet the pre-defined quality condition, select a second target candidate value from a plurality of second candidate values based on the second quality indicator set corresponding to the second reference values, and determine a plurality of third reference values based on the plurality of second reference values and the second target candidate value, the plurality of second candidate values including first candidate values other than the first target candidate values in the plurality of first candidate values;

the quality detection module 802 can be further configured to perform a third quality detection on the original layout according to the plurality of third reference values by using the quality detection tool to obtain third quality indicator set comprising one or more third quality indicators corresponding to the third reference values; and

the determination module 803 can be further configured to: in a case that the third quality indicator set corresponding to the third reference values meets the pre-defined quality condition, determine the target value of the target parameter of the quality detection tool using the third reference values.

In a possible implementation, the determination module 803 can be configured to: adjust the pre-set value range of the target parameter to obtain a second value range of the target parameter; divide the second value range into a plurality of second value intervals; perform a sampling in the second value intervals to obtain a plurality of first supplementary values and a plurality of second supplementary values; determine the plurality of first supplementary values and first candidate values other than the first target candidate values among the plurality of first candidate values as the plurality of second candidate values; determine the second target candidate value from the plurality of second candidate values based on the second quality indicator set corresponding to the second reference values; and determine the plurality of second supplementary values, the plurality of second reference values, and the second target candidate value as the plurality of third reference values.

In a possible implementation, the determination module 803 can be configured to: determine a first quality indicator not greater than a first indicator threshold from the first quality indicator set corresponding to the first reference values; determine a second quality indicator not greater than a second indicator threshold from the second quality indicator set corresponding to the second reference values; in a case that the determined first quality indicator is less than the determined second quality indicator, reduce the pre-set value range to obtain the second value range; and in a case that the determined first quality indicator is greater than the determined second quality indicator, expand the pre-set value range to obtain the second value range.

In a possible implementation, a length of the second value range can be not less than a first length, and the length of the second value range can be not greater than a second length.

In a possible implementation, the determination module 803 can be configured to: for the respective first reference value of the plurality of first reference values, adjust the respective first reference value based on the first target candidate value to obtain an adjusted reference value corresponding to the respective first reference value; and determine adjusted reference values corresponding to the respective first reference values as the plurality of second reference values.

In a possible implementation, the respective second reference value can correspond to one quality indicator, and the determination module 803 can be configured to: select a second reference value, which the second quality indicator corresponding to is greater than or less than a set threshold, from the plurality of second reference values, and use the selected second reference value as the target value.

In a possible implementation, the respective second reference value can correspond to a plurality of quality indicators, and the determination module 803 can be configured to: for the respective quality indicator of the plurality of quality indicators, determine a maximum value and a minimum value of the respective quality indicator from the respective second quality indicators corresponding to the respective second reference values;

for the respective second quality indicator corresponding to the respective second reference value, determine a priority indicator of the respective second quality indicator corresponding to the respective second reference value based on a second selected quality indicator and the maximum value and the minimum value of the second selected quality indicator, the second selected quality indicator being at least one of the plurality of second quality indicators corresponding to the respective second reference value, the second selected quality indicator including the respective second quality indicator corresponding to the respective second reference value; determine a target quality indicator from the respective second quality indicators corresponding to the respective second reference values based on the priority indicator of the respective second quality indicators corresponding to the respective second reference values; and determine a second reference value corresponding to the target quality indicator as the target value.

In the foregoing apparatus, a target parameter of a quality detection tool can include first reference values, and a first quality detection can be performed on an original layout by using the quality detection tool to obtain one or more first quality indicators corresponding to the first reference values. If the first quality indicators corresponding to the first reference values do not meet a pre-defined quality condition, a first target candidate value can be determined from a plurality of first candidate values of the target parameter based on the first quality indicators corresponding to the first reference values, and a plurality of second reference values of the target parameter can be determined based on the plurality of first reference values and the first target candidate value. The second reference values can be determined, so that the accuracy of a value space of the target parameter is improved. A second quality detection is performed on the original layout by using the quality detection tool to obtain one or more second quality indicators corresponding to the second reference values. The accuracy of the value space of the target parameter can be improved, to improve the accuracy of the quality detection tool, so that the accuracy of quality indicators can be improved, and in a case that the second quality indicators corresponding to the second reference values meet the pre-defined quality condition, a target value of the target parameter can be accurately determined based on the second reference values, thereby ensuring the accuracy of the quality detection tool, helping to improve the accuracy of quality indicators of to-be-detected layouts determined by the quality detection tool, and more accurately selecting a layout with better quality from the to-be-detected layouts.

When the foregoing apparatus provided in FIG. 8 implements functions thereof, the division of the foregoing functional modules can be merely used as an example for description. In practice, the foregoing functions may be assigned to and completed by different functional modules as required. That is, an internal structural division of the device may be divided into different functional modules to complete all or some of the functions described above. In addition, the information storage apparatus provided in the foregoing embodiment can belong to the same conception as the embodiment of the information storage method. For a specific implementation process thereof, refer to the method embodiment. Details are not described herein again.

FIG. 9 is a schematic block diagram of a terminal device 900 according to an exemplary embodiment of this application. The terminal device 900 can include a processor 901 and a memory 902.

The processor 901 may include one or more processing cores such as a 4-core processor or an 8-core processor. The processor 901 may be implemented by using at least one hardware form of a digital signal processor (DSP), a field programmable gate array (FPGA), and a programmable logic array (PLA). The processor 901 may alternatively include a main processor and a coprocessor. The main processor can be configured to process data in an active state, also referred to as a central processing unit (CPU). The coprocessor can be a low-power processor configured to process data in a standby state. In some embodiments, the processor 901 may be integrated with a graphics processing unit (GPU). The GPU can be configured to render and draw content that needs to be displayed on a display. In some embodiments, the processor 901 may further include an artificial intelligence (AI) processor. The AI processor can be configured to process a computing operation related to machine learning.

The memory 902 may include one or more computer-readable storage media. The computer-readable storage media may be non-transient. The memory 902 may further include a high-speed random access memory and a non-volatile memory, such as one or more magnetic disk storage devices or a flash storage device. In some embodiments, the non-transient computer-readable storage medium in the memory 902 can be configured to store at least one computer program, and the at least one computer program can be configured to be executed by the processor 901 to cause the terminal device 900 to implement the method for determining a parameter of a quality detection tool provided in the method embodiments of this application.

In some embodiments, the terminal device 900 may include a display screen 905.

The display screen 905 can be configured to display a UI. The UI may include a graph, a text, an icon, a video, and any combination thereof. When the display screen 905 can be a touch display screen, the display screen 905 can be further capable of collecting a touch signal on or above a surface of the display screen 905. The touch signal may be used as a control signal to be inputted to the processor 901 for processing. In this case, the display screen 905 may further be configured to provide a virtual button and/or a virtual keyboard that are/is also referred to as a soft button and/or a soft keyboard. In some embodiments, there may be one display screen 905, disposed on a front panel of the terminal device 900. In some other embodiments, there may be at least two display screens 905, respectively disposed on different surfaces of the terminal device 900 or designed in a foldable shape. In some other embodiments, the display screen 905 may be a flexible display screen, disposed on a curved surface or a folded surface of the terminal device 900. Even, the display screen 905 may be further set to have a non-rectangular irregular pattern, that is, a special-shaped screen. The display screen 905 may be made of materials such as a liquid crystal display (LCD) and an organic light-emitting diode (OLED). For example, the original layout, the predicted layout, the to-be-detected layout, and the like may be displayed through the display screen 905.

A person skilled in the art may understand that the structure shown in FIG. 9 does not constitute a limitation to the terminal device 900, and the terminal may include more components or fewer components than those shown in the figure, or some components may be combined, or a different component deployment may be used

FIG. 10 is a schematic structural diagram of a server according to an embodiment of this application. The server 1000 may vary greatly due to different configurations or performance, and may include one or more processors 1001 and one or more memories 1002. The one or more memories 1002 can store at least one computer program, the at least one computer program being loaded and executed by the one or more processors 1001 to implement the method for determining a parameter of a quality detection tool provided in the foregoing method embodiments. For example, the processor 1001 can be a CPU. Certainly, the server 1000 may also have a wired or wireless network interface, a keyboard, an input/output interface and other components to facilitate input/output. The server 1000 may also include other components for implementing device functions. Details are not described herein again.

In exemplary embodiments, a non-volatile computer-readable storage medium is further provided, the non-volatile computer-readable storage medium having at least one computer program stored therein, the at least one computer program being loaded and executed by a processor, to cause an electronic device to implement any foregoing method for determining a parameter of a quality detection tool.

In some embodiments, the foregoing non-volatile computer-readable storage medium may be a read-only memory (ROM), a random access memory (RAM), a compact disc ROM (CD-ROM), a magnetic tape, a floppy disk, an optical data storage device, or the like.

In exemplary embodiments, a computer program is further provided, at least one computer program product being provided, the at least one computer program being loaded and executed by a processor, to cause an electronic device to implement any foregoing method for determining a parameter of a quality detection tool.

In exemplary embodiments, a computer program product is further provided, the computer program product having at least one computer program stored therein, the at least one computer program being loaded and executed by a processor, to cause an electronic device to implement any foregoing method for determining a parameter of a quality detection tool.

"Plurality of" mentioned in this specification means two or more. "And/or" describes an association relationship for describing associated objects and represents that three relationships may exist. For example, A and/or B may represent the following three cases: only A exists, both A and B exist, and only B exists. The character "/" generally indicates an "or" relationship between the associated objects.

The foregoing descriptions can be merely examples of the embodiments of this application, but can be not intended to limit this application. Any modification, equivalent replacement, or improvement made without departing from the spirit and principle of this application shall fall within the protection scope of this application.

**Claims**

1. A method for determining a parameter of a quality detection tool, executable by an electronic device, the method comprising:

determining, for a target parameter of a quality detection tool, a plurality of first reference values within a pre-set value range and determining, from the pre-set value range excluding the determined first reference values, a plurality of first candidate values;
performing a first quality detection on an original layout using the quality detection tool and based on the first reference values to obtain a first quality indicator set comprising one or more first quality indicators;
in a case that the first quality indicator set does not meet a pre-defined quality condition, selecting a first target candidate value from the first candidate values based on the first quality indicator set, and determining, for the target parameter, a plurality of second reference values based on the first reference values and the first target candidate value;
performing a second quality detection on the original layout using the quality detection tool and based on the second reference values to obtain a second quality indicator set comprising one or more second quality indicators; and
in a case that the second quality indicator set meets the pre-defined quality condition, determining a target value of the target parameter of the quality detection tool using the second reference values.

2. The method according to claim 1, wherein the determining, for a target parameter of a quality detection tool, a plurality of first reference values within a pre-set value range and determining, from the pre-set value range excluding the determined first reference values, a plurality of first candidate values comprises:

acquiring a first value range of the target parameter as the pre-set value range;
dividing the first value range into a plurality of first value intervals; and
performing a sampling in the first value intervals to obtain the first reference values and the first candidate values.

3. The method according to claim 2, wherein the performing a sampling in the first value intervals to obtain the first reference values and the first candidate values comprises:

performing the sampling in the first value intervals to obtain a plurality of first initial values of the target parameter;
clustering the plurality of first initial values to obtain a plurality of target clusters, each of the target clusters comprising at least one first initial value; and
selecting at least one first initial value from the respective target cluster as the first reference values, and determining the first initial values other than the selected at least one first initial value in the respective target cluster as the first candidate values.

4. The method according to any one of claims 1 to 3, wherein the performing a first quality detection on an original layout using the quality detection tool and based on the first reference values to obtain a first quality indicator set comprising one or more first quality indicators comprises:
processing the original layout using the quality detection tool and based on the first reference values to obtain predicted layouts, and determining the first quality indicator set based on the predicted layouts.

5. The method according to claim 4, wherein the determining the first quality indicator set based on the predicted layouts comprises:

determining an error between the original layout and the predicted layout corresponding to the respective first reference value; and
determining at least one first quality indicator corresponding to the respective first reference value based on the error between the original layout and the predicted layout corresponding to the respective first reference value.

6. The method according to any one of claim 1 to 5, wherein the selecting a first target candidate value from the first candidate values based on the first quality indicator set comprises:

determining at least one evaluation indicator for the respective first candidate value based on at least one first quality indicator corresponding to the respective first reference value, wherein the at least one evaluation indicator for the respective first candidate value describes a possibility that a quality indicator meets the pre-defined quality condition when a quality detection is performed on the original layout using the quality detection tool in a case that the target parameter comprises the respective first candidate value; and
determining the first target candidate value from the first candidate values based on the at least one evaluation indicator for the respective first candidate value.

7. The method according to claim 6, wherein the determining at least one evaluation indicator for the respective first candidate value based on at least one first quality indicator corresponding to the respective first reference value comprises:

determining a first mapping relationship based on the respective first reference value and the at least one first quality indicator corresponding to the respective first reference value, the first mapping relationship being configured for describing a mapping relationship between the respective first reference value and statistical information of a statistical distribution in a case that the at least one first quality indicator corresponding to the respective first reference value meets the statistical distribution; and
for the respective first candidate value, determining statistical information corresponding to the respective first candidate value based on the respective first candidate value and the first mapping relationship, and determining the at least one evaluation indicator for the respective first candidate value based on the statistical information corresponding to the respective first candidate value.

8. The method according to claim 7, wherein the statistical information corresponding to the respective first candidate value comprises a mean value and a variance; and the determining the at least one evaluation indicator for the respective first candidate value based on the statistical information corresponding to the respective first candidate value comprises:

determining a reference quality indicator from the at least one first quality indicator corresponding to the respective first reference value; determining a normal distribution function corresponding to the respective first candidate value based on the reference quality indicator and the mean value and the variance corresponding to the respective first candidate value; and determining the at least one evaluation indicator for the respective first candidate value based on the variance corresponding to the respective first candidate value, the normal distribution function corresponding to the respective first candidate value, and a cumulative density function and a probability density function of the normal distribution function corresponding to the respective first candidate value.

9. The method according to claim 8, wherein the respective first reference value corresponds to one first quality indicator; and the determining a reference quality indicator from the the at least one first quality indicator corresponding to the respective first reference value comprises:
determining the smallest quality indicator from the at least one first quality indicator corresponding to the respective first reference value as the reference quality indicator.

10. The method according to claim 8, wherein the respective first reference value corresponds to a plurality of first quality indicators; and the determining a reference quality indicator from the the at least one first quality indicator corresponding to the respective first reference value comprises:

for the respective first quality indicator, determining a maximum value and a minimum value of the respective first quality indicator from the respective first quality indicator corresponding to the respective first reference value; for the respective first quality indicator, determining a priority indicator of the respective first quality indicator corresponding to the respective first reference value based on a first selected quality indicator, a weight of the first selected quality indicator, and the maximum value and the minimum value of the first selected quality indicator, the first selected quality indicator being at least one of a plurality of the first quality indicators corresponding to the respective first reference value, the first selected quality indicator comprising the respective first quality indicator corresponding to the respective first reference value; and
determining the reference quality indicator from the respective first quality indicator corresponding to the respective first reference value based on the priority indicator of the respective first quality indicator corresponding to the respective first reference value.

11. The method according to any one of claims 8 to 10, wherein the determining a normal distribution function corresponding to the respective first candidate value based on the reference quality indicator and the mean value and the variance corresponding to the respective first candidate value comprises:

determining a difference between the reference quality indicator and the mean value corresponding to the respective first candidate value; and
using a quotient of the difference by the variance corresponding to the respective first candidate value as the normal distribution function corresponding to the respective first candidate value.

12. The method according to any one of claims 8 to 11, wherein the determining the at least one evaluation indicator for the respective first candidate value based on the variance corresponding to the respective first candidate value, the normal distribution function corresponding to the respective first candidate value, and a cumulative density function and a probability density function of the normal distribution function corresponding to the respective first candidate value comprises:

multiplying the normal distribution function corresponding to the respective first candidate value by the cumulative density function of the normal distribution function corresponding to the respective first candidate value to obtain a multiplication result;
adding the multiplication result to the probability density function of the normal distribution function corresponding to the respective first candidate value to obtain an addition result; and
multiplying the addition result by the variance corresponding to the respective the first candidate value to obtain the at least one evaluation indicator for the respective first candidate value.

13. The method according to any one of claim 6 to 12, wherein the respective first candidate value corresponds to one evaluation indicator, and the determining the first target candidate value from the first candidate values based on the at least one evaluation indicator for the respective first candidate value comprises:
selecting a first candidate value, which the evaluation indicator corresponding to is not less than a set indicator threshold, from the first candidate values based on the evaluation indicator corresponding to the respective first candidate value, as the first target candidate value.

14. The method according to any one of claim 6 to 12, wherein the respective first candidate value corresponds to a plurality of evaluation indicators; and the determining the first target candidate value from the first candidate values based on the at least one evaluation indicator for the respective first candidate value comprises:

for the respective evaluation indicator of a plurality of evaluation indicators, determining a maximum value and a minimum value of the respective evaluation indicator from the respective evaluation indicator corresponding to the respective first candidate value;
for the respective evaluation indicator corresponding to the respective first candidate value, determining a priority indicator of the respective evaluation indicator corresponding to the respective first candidate value based on a selected evaluation indicator and the maximum value and the minimum value of the selected evaluation indicator, the selected evaluation indicator being at least one of the plurality of evaluation indicators corresponding to the respective first candidate value, the selected evaluation indicator comprising the respective evaluation indicator corresponding to the respective first candidate value; and
determining a target indicator from the respective evaluation indicator corresponding to the respective first candidate values based on the priority indicator of the respective evaluation indicator corresponding to the respective first candidate value; and determining a first candidate value corresponding to the target indicator as the first target candidate value.

15. The method according to any one of claims 1 to 14, wherein the method further comprises:

in a case that the second quality indicator set does not meet the pre-defined quality condition, selecting a second target candidate value from a plurality of second candidate values based on the second quality indicator set, and determining a plurality of third reference values based on the second reference values and the second target candidate value, the second candidate values comprising first candidate values other than the first target candidate values in the plurality of first candidate values;
performing a third quality detection on the original layout using the quality detection tool and based on the third reference values to obtain a third quality indicator set comprising one or more third quality indicators; and
in a case that the third quality indicator set meets the pre-defined quality condition, determining the target value of the target parameter of the quality detection tool using the third reference values.

16. The method according to claim 15, wherein the selecting a second target candidate value from a plurality of second candidate values based on the second quality indicator set, and determining a plurality of third reference values based on the second reference values and the second target candidate value comprises:

adjusting the pre-set value range of the target parameter to obtain a second value range of the target parameter;
dividing the second value range into a plurality of second value intervals;
performing a sampling in the second value intervals to obtain a plurality of first supplementary values and a plurality of second supplementary values;
determining the first supplementary values and the first candidate values other than the first target candidate values among the first candidate values as the second candidate values;
determining the second target candidate value from the second candidate values based on the second quality indicator set; and
determining the plurality of second supplementary values, the plurality of second reference values, and the second target candidate value as the plurality of third reference values.

17. The method according to claim 16, wherein the adjusting the pre-set value range of the target parameter to obtain a second value range of the target parameter comprises:

determining a first quality indicator not greater than a first indicator threshold from the first quality indicator set;
determining a second quality indicator not greater than a second indicator threshold from the second quality indicator set;
in a case that the determined first quality indicator is less than the determined second quality indicator, reducing the pre-set value range to obtain the second value range; and
in a case that the determined first quality indicator is greater than the determined second quality indicator, expanding the pre-set value range to obtain the second value range.

**18.** The method according to claim 17, wherein a length of the second value range is not less than a first length, and the length of the second value range is not greater than a second length.

**19.** The method according to any one of claim 1 to 18, wherein the determining, for the target parameter, a plurality of second reference values based on the first reference values and the first target candidate value comprises:

> for the respective first reference value, adjusting the respective first reference value based on the first target candidate value to obtain an adjusted reference value corresponding to the respective first reference value; and
> determining the adjusted reference values corresponding to the respective first reference value as the plurality of second reference values.

**20.** The method according to any one of claim 1 to 19, wherein the respective second reference value corresponds to one second quality indicator, and the determining a target value of the target parameter of the quality detection tool using the second reference values comprises:
selecting a second reference value, which the second quality indicator corresponding to is greater than or less than a set threshold, from the plurality of second reference values as the target value.

**21.** The method according to any one of claim 1 to 19, wherein the respective second reference value corresponds to a plurality of second quality indicators, and the determining a target value of the target parameter of the quality detection tool using the second reference values comprises:

> for the respective second quality indicator of the plurality of second quality indicators, determining a maximum value and a minimum value of the respective second quality indicator from the respective second quality indicator corresponding to the respective second reference value;
> for the respective second quality indicator corresponding to the respective second reference value, determining a priority indicator of the respective second quality indicator corresponding to the respective second reference value based on a second selected quality indicator and the maximum value and the minimum value of the second selected quality indicator, the second selected quality indicator being at least one of the plurality of second quality indicators corresponding to the respective second reference value, the second selected quality indicator comprising the respective second quality indicator corresponding to the respective second reference value; and
determining a target quality indicator from the respective second quality indicator corresponding to the respective second reference value based on the priority indicator of the respective second quality indicator corresponding to the respective second reference value; and determining a second reference value corresponding to the target quality indicator as the target value.

**22.** An apparatus for determining a parameter of a quality detection tool, the apparatus comprising:

> an acquisition module, configured to determine, for a target parameter of a quality detection tool, a plurality of first reference values within a preset value range and determine a plurality of first candidate values from the pre-set value range excluding the determined first reference values;
> a quality detection module, configured to perform a first quality detection on an original layout using the quality detection tool and based on the plurality of first reference values to obtain a first quality indicator set comprising one or more first quality indicators; and
> a determination module, configured to: in a case that the first quality indicator set does not meet a pre-defined quality condition, select a first target candidate value from the first candidate values based on the first quality indicator set, and determine, for the target parameter, a plurality of second reference values based on the first reference values and the first target candidate value;
> the quality detection module being further configured to perform a second quality detection on the original layout using the quality detection tool and based on the second reference values to obtain a second quality indicator set comprising one or more second quality indicators;
> the determination module being further configured to: in a case that the second quality indicator set meets the pre-defined quality condition, determine a target value of the target parameter of the quality detection tool using the second reference values.

**23.** The apparatus according to claim 22, wherein the acquisition module is configured to: acquire a first value range of the target parameter as the pre-set value range; divide the first value range into a plurality of first value intervals; and perform a sampling in the first value intervals to obtain the first reference values and the first candidate values.

**24.** The apparatus according to claim 23, wherein the acquisition module is configured to: perform the sampling in the first value intervals to obtain a plurality of first initial values of the target parameter; cluster the plurality of first initial values to obtain a plurality of target clusters, each of the target clusters comprising at least one first initial value; and select at least one first initial value from the respective target cluster as the first reference values, and determine the first initial values other than the selected at least one first initial values in the respective target cluster as the first candidate values.

25. The apparatus according to any one of claims 22 to 24, wherein the quality detection module is configured to: process the original layout using the quality detection tool and based on the first reference values to obtain predicted layouts, and determine the first quality indicator set based on the predicted layouts.

26. The apparatus according to claim 25, wherein the quality detection module is configured to: determine an error between the original layout and a predicted layout corresponding to the respective first reference value; and determine at least one first quality indicator corresponding to the respective first reference value based on the error between the original layout and the predicted layout corresponding to the respective first reference value.

27. The apparatus according to any one of claims 22 to 26, wherein the determination module is configured to: determine at least one evaluation indicator for the respective first candidate value based on at least one first quality indicator corresponding to the respective first reference value , wherein the at least one evaluation indicator for the respective first candidate value describes a possibility that a quality indicator meets the pre-defined quality condition when a quality detection is performed on the original layout using the quality detection tool in a case that the target parameter comprises the respective first candidate value; and determine the first target candidate value from the first candidate values based on the at least one evaluation indicator for the respective first candidate value.

28. The apparatus according to claim 27, wherein the determination module is configured to: determine a first mapping relationship based on the respective first reference value and the at least one first quality indicator corresponding to the respective first reference value , the first mapping relationship being configured for describing a mapping relationship between the respective first reference value and statistical information of a statistical distribution in a case that the at least one first quality indicator corresponding to the respective first reference value meets the statistical distribution; and for the respective first candidate value, determine statistical information corresponding to the respective first candidate value based on the respective first candidate value and the first mapping relationship, and determine the at least one evaluation indicator for the respective first candidate value based on the statistical information corresponding to the respective first candidate value.

29. The apparatus according to claim 28, wherein the statistical information corresponding to the respective first candidate value comprises a mean value and a variance; and the determination module is configured to: determine a reference quality indicator from the at least one first quality indicator; determine a normal distribution function corresponding to the respective first candidate value based on the reference quality indicator and the mean value and the variance corresponding to the respective first candidate value; and determine the at least one evaluation indicator for the respective first candidate value based on the variance corresponding to the respective first candidate value, the normal distribution function corresponding to the respective first candidate value, and a cumulative density function and a probability density function of the normal distribution function corresponding to the respective first candidate value.

30. The apparatus according to claim 29, wherein the respective first reference value corresponds to one first quality indicator; and the determination module is configured to: determine the smallest first quality indicator from the at least one first quality indicator corresponding to the respective first reference value as the reference quality indicator.

31. The apparatus according to claim 29, wherein the respective first reference value corresponds to a plurality of first quality indicators; and the determination module is configured to: for the respective first quality indicator, determine a maximum value and a minimum value of the respective first quality indicator from the respective first quality indicators corresponding to the respective first reference value; for the respective first quality indicator, determine a priority indicator of the respective first quality indicator corresponding to the respective first reference value based on a first selected quality indicator, a weight of the first selected quality indicator, and the maximum value and the minimum value of the first selected quality indicator, the first selected quality indicator being at least one of a plurality of the first quality indicators corresponding to the respective, the first selected quality indicator comprising the respective first quality indicator corresponding to the respective first reference value; and determine the reference quality indicator from the respective first quality indicators corresponding to the respective first reference value based on the priority indicator of the respective first quality indicator corresponding to the respective first reference value.

32. The apparatus according to any one of claims 29 to 31, wherein the determination module is configured to: determine a difference between the reference quality indicator and the mean value corresponding to the respective first candidate value; and use a quotient of the difference by the variance corresponding to the respective first candidate value as the normal distribution function corresponding to the respective first candidate value.

33. The apparatus according to any one of claims 29 to 32, wherein the determination module is configured to: multiply the normal distribution function corresponding to the respective first candidate value by the cumulative density function of the normal distribution function corresponding to the respective to obtain a multiplication result; add the multiplication result to the probability density function of the normal distribution function corresponding to the respective first candidate value to obtain an addition result; and multiply the addition result by the variance corresponding to the respective first candidate value to obtain the at least one evaluation indicator for the respective first candidate value.

34. The apparatus according to any one of claims 27 to 33, wherein the respective candidate value corresponds to one evaluation indicator, and the determination module is configured to select a first candidate value, which the evaluation indicator corresponding to is not less than a set indicator threshold, from the first candidate values based on the evaluation indicator corresponding to the respective the first candidate values as the first target candidate value.

35. The apparatus according to any one of claims 27 to 33, wherein the respective candidate value corresponds to a plurality of evaluation indicators; and the determination module is configured to: for the respective evaluation indicator of a plurality of evaluation indicators, determine a maximum value and a minimum value of the respective evaluation indicator from the respective evaluation indicators corresponding to the respective first candidate values; for the respective evaluation indicator corresponding to the respective first candidate value, determine a priority indicator of the respective evaluation indicator corresponding to the respective first candidate value based on a selected evaluation indicator and the maximum value and the minimum value of the selected evaluation indicator, the selected evaluation indicator being at least one of the plurality of evaluation indicators corresponding to the respective first candidate value, the selected evaluation indicator comprising the respective evaluation indicator corresponding to the respective first candidate value; determine a target indicator from the respective evaluation indicators corresponding to the respective first candidate values based on the priority indicators of the respective evaluation indicator corresponding to the respective first candidate values; and determine a first candidate value corresponding to the target indicator as the first target candidate value.

36. The apparatus according to any one of claims 22 to 35, wherein the determination module is further configured to: in a case that the second quality indicator set does not meet the pre-defined quality condition, select a second target candidate value from a plurality of second candidate values based on the second quality indicator set, and determine a plurality of third reference values based on the second reference values and the second target candidate value, the second candidate values comprising first candidate values other than the first target candidate values in the plurality of first candidate values;

   the quality detection module is further configured to perform a third quality detection on the original layout using the quality detection tool and based on the plurality of third reference values to obtain a third quality indicator set comprising one or more third quality indicators; and
   the determination module is further configured to: in a case that the third quality indicator set meets the pre-defined quality condition, determine the target value of the target parameter of the quality detection tool using the third reference values.

37. The apparatus according to claim 36, wherein the determination module is configured to: adjust the pre-set value range of the target parameter to obtain a second value range of the target parameter; divide the second value range into a plurality of second value intervals; perform a sampling in the second value intervals to obtain a plurality of first supplementary values and a plurality of second supplementary values; determine the first supplementary values and the first candidate values other than the first target candidate values among the first candidate values as the second candidate values; determine the second target candidate value from the second candidate values based on the second quality indicator set; and determine the plurality of second supplementary values, the plurality of second reference values, and the second target candidate value as the plurality of third reference values.

38. The apparatus according to claim 37, wherein the determination module is configured to: determine a first quality indicator not greater than a first indicator threshold from the first quality indicator set; determine a second quality indicator not greater than a second indicator threshold from the second quality indicator set; in a case that the determined first quality indicator is less than the determined second quality indicator, reduce the pre-set value range to obtain the second value range; and in a case that the determined first quality indicator is greater than the determined second quality indicator, expand the pre-set value range to obtain the second value range.

39. The apparatus according to claim 38, wherein a length of the second value range is not less than a first length, and the length of the second value range is not greater than a second length.

40. The apparatus according to any one of claims 22 to 39, wherein the determination module is configured to: for the respective first reference value, adjust the respective first reference value based on the first target candidate value to obtain an adjusted reference value corresponding to the respective first reference value; and determine the adjusted reference values corresponding to the respective first reference value as the plurality of second reference values.

41. The apparatus according to any one of claims 22 to 40, wherein the respective second reference value corresponds one second quality indicator, and the determination module is configured to: select a second reference value, which the second quality indicator corresponding to is greater than or less than a set threshold, from the plurality of second reference values as the target value.

42. The apparatus according to any one of claims 22 to 40, wherein the respective second reference value corresponds to a plurality of second quality indicators, and the determination module is configured to: for the respective second quality indicator of the plurality of second quality indicators, determine a maximum value and a minimum value of the respective second quality indicator from the respective second quality indicator corresponding to the respective second reference values; for the respective second quality indicator corresponding to the respective second reference value, determine a priority indicator of the respective second quality indicator corresponding to the respective second reference value based on a second selected quality indicator and the maximum value and the minimum value of the second selected quality indicator, the second selected quality indicator being at least one of the plurality of second quality indicators corresponding to the respective second reference value, the second selected quality indicator comprising the respective second quality indicator corresponding to the respective second reference value; determine a target quality indicator from the respective second quality indicator corresponding to the respective second reference value based on the priority indicator of the respective second quality indicator corresponding to the respective second reference value; and determine a second reference value corresponding to the target quality indicator as the target value.

43. An electronic device, the electronic device comprising a processor and a memory, the memory having at least one computer program stored therein, the at least one computer program being loaded and executed by the processor, to cause the electronic device to implement the method for determining a parameter of a quality detection tool according to any one of claims 1 to 21.

44. A non-volatile computer-readable storage medium, the non-volatile computer-readable storage medium having at least one computer program stored therein, the at least one computer program being loaded and executed by a processor, to cause an electronic device to implement the method for determining a parameter of a quality detection tool according to any one of claims 1 to 21.

45. A computer program product, the computer program product having at least one computer program stored therein, the at least one computer program being loaded and executed by a processor, to cause an electronic device to implement the method for determining a parameter of a quality detection tool according to any one of claims 1 to 21.

FIG. 1

determine, for a target parameter of a quality detection tool, a plurality of first reference values within a pre-set value range and determine, from the pre-set value range excluding the determined first reference values, a plurality of first candidate values — 201

perform a first quality detection on an original layout using the quality detection tool and based on the first reference values to obtain a first quality indicator set comprising one or more first quality indicators

In a case that the first quality indicator set does not meet a pre-defined quality condition, select a first target candidate value from the first candidate values based on the first quality indicator set, and determine, for the target parameter, a plurality of second reference values based on the first reference values and the first target candidate value

perform a second quality detection on the original layout using the quality detection tool and based on the second reference values to obtain a second quality indicator set comprising one or more second quality indicators

in a case that the second quality indicator set meets the pre-defined quality condition, determine a target value of the target parameter of the quality detection tool using the second reference values

FIG. 2

FIG. 3

FIG. 4

FIG. 5

FIG. 6

FIG. 7

Apparatus for determining a
parameter of a quality detection tool

801

Acquisition
module

802

Quality detection
module

803

Determination
module

FIG. 8

900

901

Processor

905

Display

902

Memory

FIG. 9

Server 1000

1001

Processor

1002

Memory

FIG. 10

## INTERNATIONAL SEARCH REPORT

| International application No. |
| --- |
| **PCT/CN2023/131179** |

| A. | CLASSIFICATION OF SUBJECT MATTER |
| --- | --- |
| | G06F 18/23213(2023.01)i |

According to International Patent Classification (IPC) or to both national classification and IPC

| B. | FIELDS SEARCHED |
| --- | --- |

Minimum documentation searched (classification system followed by classification symbols)

　　IPC: G06F 18/-, G06Q 10/-, G06Q 5/-, G06F 30/-

Documentation searched other than minimum documentation to the extent that such documents are included in the fields searched

Electronic data base consulted during the international search (name of data base and, where practicable, search terms used)

　　CJFD, CNTXT, DWPI, ENTXT, ENTXTC, VEN, WPABS, WPABSC, CNKI: 版图, 参数, 工具, 检测, 质量, layout, parameter?, tool?, detect+, quality

| C. | DOCUMENTS CONSIDERED TO BE RELEVANT | |
| --- | --- | --- |
| Category* | Citation of document, with indication, where appropriate, of the relevant passages | Relevant to claim No. |
| Y | CN 116341465 A (BEIJING HUADA EMPYREAN TECHNOLOGY CO., LTD.) 27 June 2023 (2023-06-27)<br>　　description, paragraphs 77-155, and claims 1-13 | 1, 4-6, 13-15, 19-22, 25-27, 34-36, 40-45 |
| Y | CN 111597729 A (BEIJING TIANZE ZHIYUN TECHNOLOGY CO., LTD.) 28 August 2020 (2020-08-28)<br>　　description, paragraphs [0028]-[0106] | 1, 4-6, 13-15, 19-22, 25-27, 34-36, 40-45 |
| A | CN 102865841 A (SHANGHAI HUALI MICROELECTRONICS CORP.) 09 January 2013 (2013-01-09)<br>　　entire document | 1-45 |
| A | CN 109491216 A (SHANGHAI INTEGRATED CIRCUIT RESEARCH AND DEVELOPMENT CENTER CO., LTD.) 19 March 2019 (2019-03-19)<br>　　entire document | 1-45 |
| A | CN 114297036 A (TENCENT TECHNOLOGY (SHENZHEN) CO., LTD.) 08 April 2022 (2022-04-08)<br>　　entire document | 1-45 |

☑ Further documents are listed in the continuation of Box C. 　　☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **23 April 2024** | **24 April 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| :--- |
| **PCT/CN2023/131179** |

| C. | DOCUMENTS CONSIDERED TO BE RELEVANT | |
| :---: | :--- | :---: |
| Category* | Citation of document, with indication, where appropriate, of the relevant passages | Relevant to claim No. |
| A | KR 20230102490 A (SEJONG INDUSTRY-ACADEMIA COOPERATION FOUNDATION HONGIK UNIVERSITY) 07 July 2023 (2023-07-07)<br>entire document | 1-45 |

Form PCT/ISA/210 (second sheet) (July 2022)

## INTERNATIONAL SEARCH REPORT
### Information on patent family members

| International application No. |
| PCT/CN2023/131179 |

| Patent document<br>cited in search report | | | Publication date<br>(day/month/year) | Patent family member(s) | Publication date<br>(day/month/year) |
|---|---|---|---|---|---|
| CN | 116341465 | A | 27 June 2023 | None | |
| CN | 111597729 | A | 28 August 2020 | None | |
| CN | 102865841 | A | 09 January 2013 | None | |
| CN | 109491216 | A | 19 March 2019 | None | |
| CN | 114297036 | A | 08 April 2022 | None | |
| KR | 20230102490 | A | 07 July 2023 | None | |

Form PCT/ISA/210 (patent family annex) (July 2022)

**REFERENCES CITED IN THE DESCRIPTION**

**Patent documents cited in the description**

- CN 202311022025